# EUROPEAN PATENT SPECIFICATION

(11) **EP 2 161 736 B1**
(45) Date of publication and mention of the grant of the patent: **18.07.2018**
(21) Application number: 09180810.5
(22) Date of filing: 08.06.2007
(51) Int. Cl.: H01L 21/027, G03F 7/20

(54) **Variable slit device, illumination device, exposure apparatus, exposure method, and device manufacturing method**
Variable Schlitzvorrichtung, Beleuchtungsvorrichtung, Belichtungsvorrichtung, Belichtungsverfahren und Vorrichtungsherstellungsverfahren
Dispositif à fente variable, dispositif d'éclairage, appareil d'exposition, procédé d'exposition et procédé de fabrication de dispositif

(30) Priority: 16.06.2006 JP 2006167234
(43) Date of publication of application: 10.03.2010
(62) Divisional of application: 07744932.0
(73) Proprietor: Nikon Corporation, Tokyo 108-6290 (JP)
(72) Inventor: Muramatsu, Kouji, Tokyo Tokyo 100-8331 (JP)
(74) Representative: Hoffmann Eitle

(56) References cited:
- US-A- 5 526 093
- US-A1- 2002 106 821
- JAKATDAR N ET AL: "In-situ Metrology for Deep Ultraviolet Lithography Process Control" 23 February 1998 (1998-02-23), PROCEEDINGS OF THE SPIE - THE INTERNATIONAL SOCIETY FOR OPTICAL ENGINEERING, SPIE, US, PAGE(S) 262 - 270 , XP007901923 ISSN: 0277-786X * abstract; figure 1 * * page 263, last paragraph * * page 269, paragraph 1 *

## Description

### TECHNICAL FIELD

The present invention relates to a variable slit device used in a lithographic process to manufacture semiconductor devices, liquid crystal display devices, thin film magnetic heads and the like, an illumination device provided with this variable slit device, an exposure apparatus provided with this illumination device, an exposure method for exposing a pattern on a substrate, and a method for manufacturing a device using the exposure apparatus or the exposure method.

### BACKGROUND ART

In a lithographic process for manufacturing semiconductor devices, liquid crystal display devices, thin film magnetic heads and the like, an exposure apparatus is used to transfer an image of a pattern formed by a mask onto a substrate coated with a photosensitive material. The patterns transferred to a substrate have become finer and more integrated. As a result, even a slight illumination non-uniformity in the illumination light illuminating the substrate would result in an uneven line width of the transferred pattern. Accordingly, illumination non-uniformity of the illumination light must be controlled with high accuracy. For example, for a scanning type exposure apparatus that relatively scans a mask and a substrate with illumination light having a slit shape to transfer a pattern, which is formed on a mask, onto the substrate, a variable slit device has been proposed to control illumination non-uniformity in the illumination light by changing the slit shape of illumination light in the longitudinal direction to obtain a uniform integrated exposure amount (refer to, for example, U.S. Patent No. 5, 895, 737) .

### DISCLOSURE OF THE INVENTION

The variable slit device of Patent Document 1 is includes a plurality of blades in the longitudinal direction of a slit to set the shape of the illumination light. The shape of the slit in the longitudinal direction is changed by moving the blades along the lateral direction of the slit. However, a predetermined length of time is required to control illumination non-uniformity in the illumination light. There is thus a concern of reduction in the throughput due to the time required to change from a slit shape corresponding to a first illumination condition to a slit shape corresponding to a second illumination condition. It is an object of the present invention to quickly change the illumination light to a desired shape.

According to the present invention a device manufacturing method is characterized by an applying step of applying photosensitive material to a substrate, a scanning exposing step of exposing a predetermined pattern onto the substrate to which the photosensitive material has been applied, a developing step of developing the substrate onto which the predetermined pattern has been exposed, and a processing step of performing predetermined processing on the substrate that has been developed. The exposing step corrects a line width uniformity error on the substrate resulting from at least one of the applying step, the developing step, and the processing step, wherein the scanning exposing step includes a first exposing step of exposing the predetermined pattern onto one of a plurality of sections on the substrate (W) with exposure light including a first accumulated exposure amount distribution in a plane of the substrate (W) and perpendicular to a scanning direction, and a second exposing step of exposing the predetermined pattern onto a different one of the plurality of sections on the substrate (W) with exposure light including a second accumulated exposure amount distribution in a plane of the substrate (W) and perpendicular to a scanning direction, that differs from the first accumulated exposure amount distribution.

Additionally, the present invention proposes an exposure apparatus for use in an applying step of applying photosensitive material to a substrate, a scanning exposing step of exposing a predetermined pattern onto the substrate to which the photosensitive material has been applied, a developing step of developing the substrate onto which the predetermined pattern has been exposed, and a processing step of performing predetermined processing on the substrate that has been developed. The exposure apparatus is characterized by correcting during the exposing step a line width uniformity error on the substrate resulting from at least one of the applying step, the developing step, and the processing step and exposing the predetermined pattern onto one of a plurality of sections on the substrate (W) with exposure light including a first accumulated exposure amount distribution, and exposing the predetermined pattern onto a different one of the plurality of sections on the substrate with exposure light including a second accumulated exposure amount distribution in a plane of the substrate (W) and perpendicular to a scanning direction, that differs from the first accumulated exposure amount distribution.

US patent publication no. 2002/0106821 (Bode et al.) discloses a method of compensating for across-wafer variations in photoresist thickness is provided. The method comprises providing a wafer having a process layer formed there-above, forming a layer of photoresist above the process layer, measuring a thickness of the layer of photoresist at a plurality of locations to result in a plurality of thickness measurements, providing the thickness measurements to a controller that determines, based upon the thickness measurements, an exposure dose of an exposure process to be performed on the layer of photoresist, and performing the exposure process on the layer of photoresist using the determined exposure dose. This exposure dose may be varied on a flash-by-flash basis as the stepper tool "steps" across the surface of wafers.

US patent publication no. 5,526,093 (Takahashi) discloses an exposure apparatus including a scanner for scanning a substrate to be exposed with an exposure beam; and an exposure amount controller for controlling an amount of exposure by the exposure beam in accordance with a position on the substrate. An exposure apparatus including a scanner for scanning a substrate to be exposed with an exposure beam; a detector for detecting a distribution of a film thickness of a radiation sensitive layer on the substrate; and an exposure amount changing controller for controlling an amount of exposure by the exposure beam in accordance with the film thickness distribution.

The article "In situ metrology for deep ultraviolet lighography process control", 262/SPIE Vol. 3332, discloses Submicron Deep Ultraviolet (DUV) photolithographic processes presenting significant manufacturing challenges due to the relatively small process windows often associated with these technologies. The sensitivity of the process to small upstream variations in incoming film reflectivity, photoresist coat and softbake steps as well as the bake plate temperature can result in the final critical dimension (CD) going out of specifications and more importantly, not being identified until the end of the lot. The pre-exposure film stack reflectance and the pre-develop exposed area photoresist thickness loss are identified as wafer state quantities, related to the final photoresist critical dimension. A control model integrating equipment and wafer state parameters has been constructed, using a designed experiment, to facilitate control of the photolithography sequence.

### BRIEF DESCRIPTION OF THE DRAWINGS

Fig. 1 is a diagram showing the structure of an exposure apparatus according to a first example
Fig. 2 is a diagram showing the structure of a variable slit device used in the exposure apparatus of the first example shown in Fig. 1;
Fig. 3 is a diagram showing the structure of a first shape setting unit in the variable slit device of the first example
Fig. 4 is a diagram showing the variable slit device of the first example in a state in which a first selection member is moved in the +X direction;
Fig. 5 shows the structure of a second shape setting unit of the variable slit device of the first example
Fig. 6 is a diagram showing the variable slit device of the first embodiment in a state in which a second selection member is moved in the -X direction;
Fig. 7 is a diagram showing a slit shape set in correspondence with a first illumination condition;
Fig. 8 is a diagram showing a slit shape set in correspondence with a second illumination condition;
Fig. 9 is a diagram showing a first modification of the variable slit device of the first example in which the first selection member is inclined relative to the Z axis;
Fig. 10 is a diagram showing a first modification of the variable slit device of the first example in which the second selection member is inclined relative to the Z axis;
Fig. 11 is a diagram showing the structure of the selection member in a second modification of the variable slit device of the first example;
Fig. 12 is a diagram showing the structure of a third modification of the variable slit device of the first example;
Fig. 13 is a flowchart showing an exposure method according to the invention;
Fig. 14 is a flowchart showing a method for manufacturing a semiconductor device, which serves as a micro device, according to a second example;
Fig. 15 is a flowchart showing a method for manufacturing a liquid crystal display element, which serves as a micro device, according to a third example;
Fig. 16 is a diagram showing an exposure method according to a fourth example, in which Fig. 16(a) shows an example of a shot array on a wafer, and Figs. 16(b) and 16(c) show a state of line width uniformity in a shot region;
Fig. 17 is a diagram showing an exposure method according to a fifth example, in which Fig. 17(a) shows an example of a shot array on a wafer, and Fig. 17(b) shows a state of line width uniformity in a shot region;
Fig. 18 is a flowchart showing an exposure method according to a fifth example;
Fig. 19 is a diagram showing an exposure method according to a sixth example and shows a state of line width uniformity in a shot region;
Fig. 20 is a diagram showing the exposure method of the sixth example and shows groups of a plurality of shot regions;
Fig. 21 is a flowchart showing an exposure method according to an seventh example;
Fig. 22 is a diagram showing the structure of an exposure apparatus according to a eight example embodiment; and
Figs. 23(a)-23(f) are diagrams showing the operation of the exposure apparatus of the eight example.

### BEST MODE FOR CARRYING OUT THE INVENTION

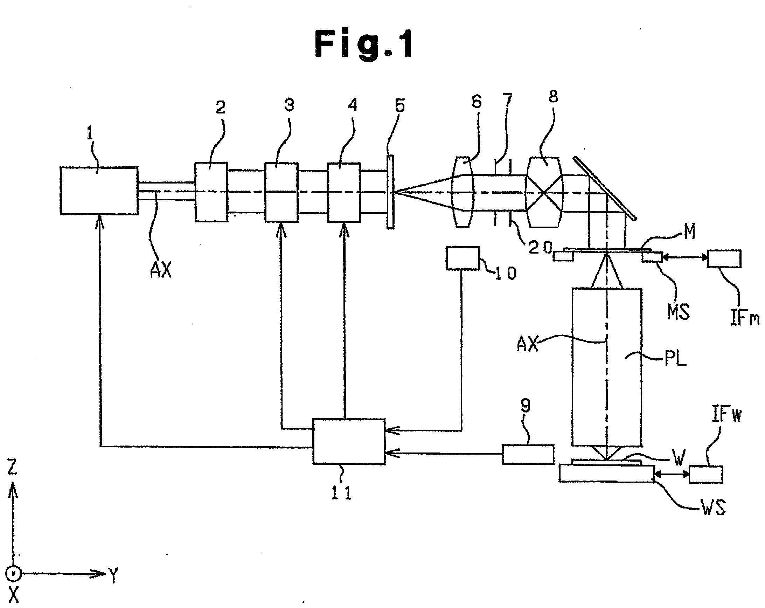

Embodiments of an exposure apparatus according to the present invention are described hereinafter with reference to the drawings. Fig. 1 is a diagram showing the structure of an exposure apparatus according to a first example. In the following description, the XYZ orthogonal coordinate system is set as shown in Fig. 1, and the positional relationships of the various members is described with reference to this orthogonal coordinate system. The XYZ orthogonal coordinate system is set so that the X axis and the Y axis are parallel to a wafer W, and the Z axis is set in a direction that intersects the wafer W. In this embodiment the direction of movement (scanning direction) of a mask M and the wafer W is set in the X axis direction.

As shown in Fig. 1, the exposure apparatus of the first example includes a light source 1, which supplies exposure light (illumination light). For example, an ArF excimer laser light source, which supplies light at a wavelength of approximately 193 nm, or a KrF laser light source, which supplies light at a wavelength of approximately 248 nm, may be used as the light source 1.

A generally parallel light beam emitted from the light source 1 is adjusted to a light beam having a predetermined rectangular cross-section when passing through a beam transmission system 2 having a known structure and then enters a polarized state changing unit 3. The beam transmission system 2 has the functions of guiding the entering light beam to the polarized state changing unit 3 while converting the light beam to a light beam having a proper cross-sectional shape and size and actively corrects positional fluctuations and angular fluctuations of the light beam entering the polarized state changing unit 3, which is in a subsequent final stage.

The polarized state changing unit 3 has the function of changing the polarized state of the illumination light (that is, the illumination light corresponding to a mask M) on the wafer W, which will be described later. Specifically, the polarized state changing unit 3 converts the entering linear polarized light to linear polarized light having a different oscillation direction, converts the entering linear polarized light to non-polarized light, or emits the entering linear polarized light without performing any conversion. The structure and operation of the polarized state changing unit 3 is controlled by a controller 11. Refer to U.S. Patent Application Publication No. 2006/0055834 for details on the structure and operation of the polarized state changing unit 3.

The light beam, the polarized state of which has been converted as required by the polarized state changing unit 3, enters a micro lens array (or fly-eye lens) 5 through a beam shaper 4. The beam shaper 4 includes, for example, a diffraction optical element and a variable magnification optical system, and has functions for changing the shape and size of an illumination field formed on an incident surface of the micro lens array 5 and changing the shape and size of a planar light source formed at a rear focal plane (illumination pupil plane) of the micro lens array 5. The controller 11 controls the operation of the beam shaper 4. A diffraction optical element and an optical integrator such as prism-shaped rod type integrator may be used in place of the micro lens array 5.

The light beam which enters the micro lens array 5 is split two-dimensionally by a plurality of micro lenses so that a light source is formed at the rear focal plane of each micro lens into which the light beam enters. A substantial planar light source (hereinafter referred to as a "secondary light source") formed by a plurality of light sources is therefore formed on the rear focal plane of the micro lens array 5. The light beam from the secondary light source formed on the rear focal plane of the micro lens array 5 passes through a condenser optical system 6 and then illuminates a mask blind 7 in an overlapped manner. The light beam may be restricted by arranging an aperture diaphragm at the rear or front side of the micro lens array 5. Refer to U.S. Patent No. 6,913,373, U.S. Patent Application Publication No. 2006/0109443, and International Patent Publication No. WO2006/070580 with regard to the micro lens array 5, which serves as an optical integrator type micro lens array 5.

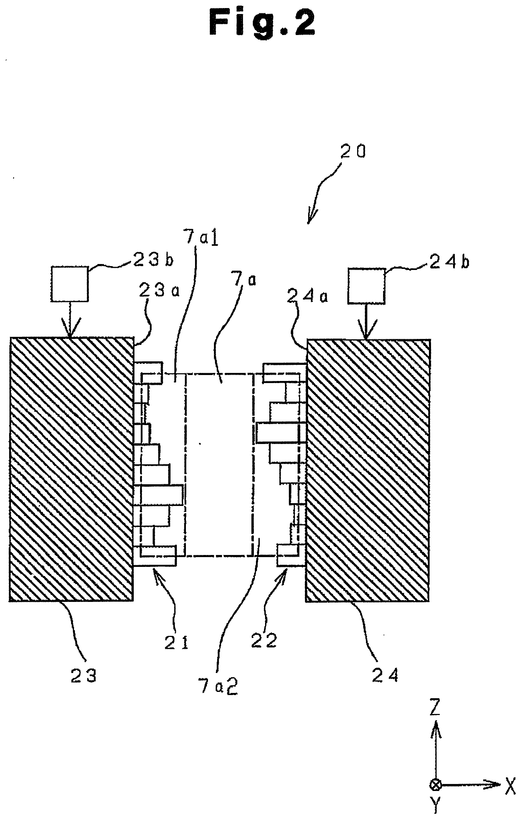

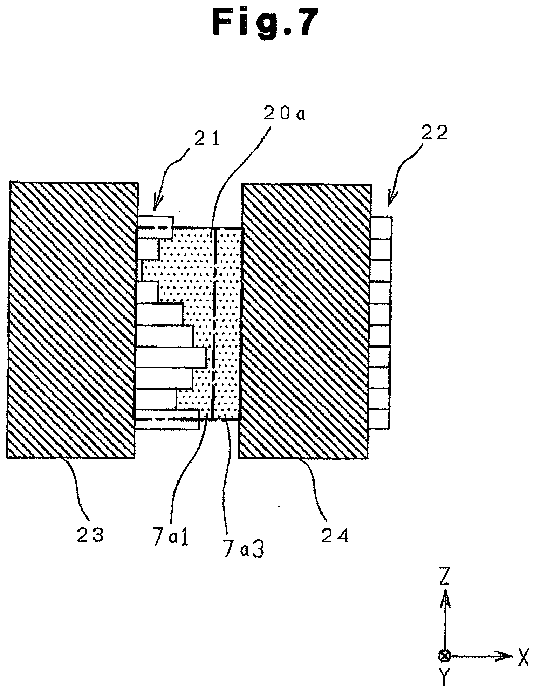

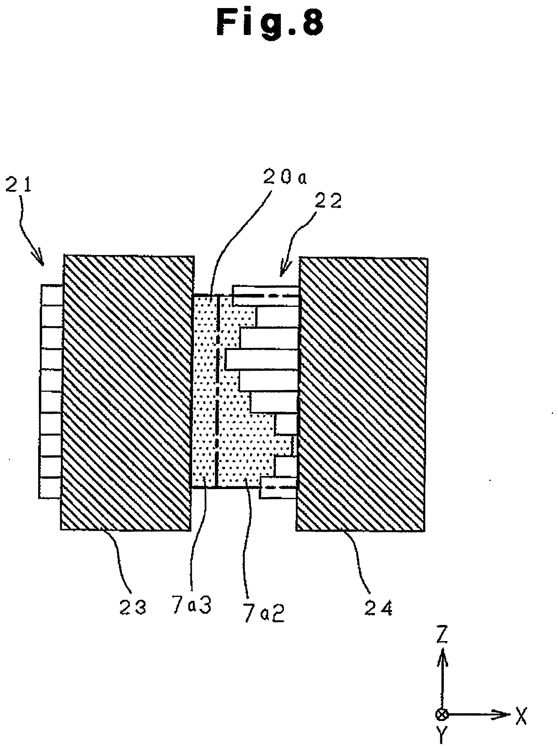

In this manner, a rectangular illumination field 7a (refer to Fig. 2), which conforms to the shape and focal length of each of the micro lenses in the micro lens array 5, is formed on the mask blind 7, which serves as a illumination view stop. After passing through the rectangular aperture (light transmission portion) of the mask blind 7, the light beam passes through a variable slit device 20, which forms illumination light with a slit shape 20a (refer to Figs. 7 and 8) extending in a longitudinal direction and a lateral direction. The variable slit device 20 is arranged at or in the vicinity of a position optically conjugated to the mask M and the wafer W, that is, in the vicinity of the mask blind 7. Details of the structure and operation of the mask blind 7 may be referred to in U.S. Patent No. 6,608,665.

Fig. 2 shows the structure of the variable slit device 20. As shown in Fig. 2, the variable slit device 20 includes a first shape setting unit 21, a second shape setting unit 22, a first selection member 23, and a second selection member 24. The first shape setting unit 21 and the second shape setting unit 22 are arranged on the -X direction side of the illumination field 7a.

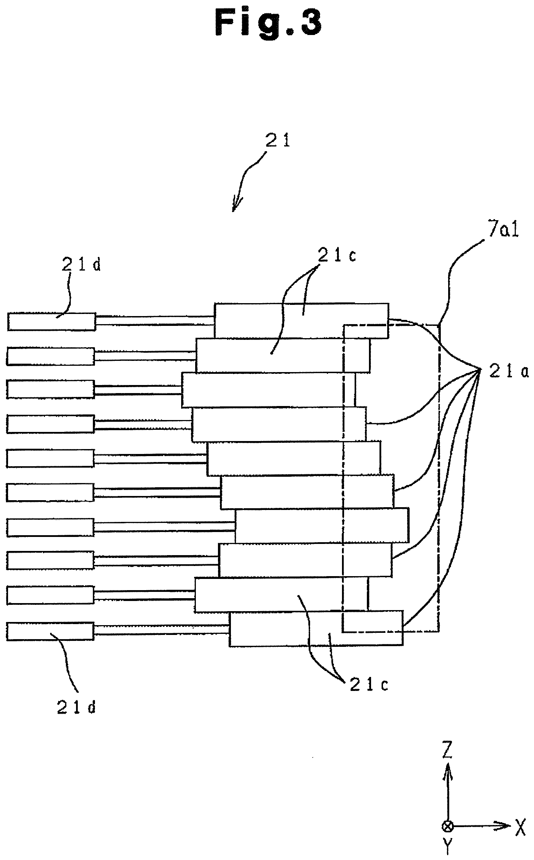

The first shape setting unit 21 sets a first light intensity distribution, which is the light intensity distribution of a first light beam portion 7a1 that passes by the vicinity of a peripheral portion 21a. Fig. 3 shows the structure of the first shape setting unit 21. As shown in Fig. 3, the first shape setting unit 21 includes a plurality of (ten in the present example blades 21c to form the edge shape of the peripheral portion 21a in order to set the first light intensity distribution. The plurality of blades 21c are formed by components which completely block light, such as stainless steel components, and are arranged in a comb-tooth pattern, without gaps, along the Z direction within a plane (XZ plane) intersecting the optical axis AX of the illumination light. A drive portion 21d is connected to each blade 21c, and the blades 21c are formed to be independently movable in the X direction when driven by the drive portions 21d. The drive portions 21d are driven and controlled by a controller 11.

The first selection member 23 has a linear edge 23a that extends in the Z direction and is located at the -Y direction side, that is, the light entrance side, of the plurality of blades 21c of the first shape setting unit 21, as shown in Fig. 2. A drive portion 23b is connected to the first selection member 23, and the first selection member 23 is formed to be movable along the X direction when driven by the drive portion 23b. The drive portion 23b is driven and controlled by the controller 11.

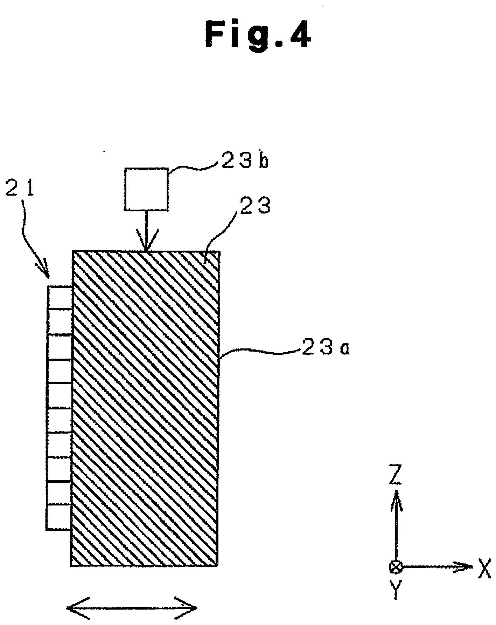

As shown in Fig. 4, the peripheral portion 21a (refer to Fig. 3), which is set by the first shape setting unit 21, is covered by the first selection member 23 when the first selection member 23 is moved along the +X direction relative to the first shape setting unit 21. That is, the first light beam portion 7a1, which is set to have a first light intensity distribution by the first shape setting unit 21, (more precisely, the entering light beam corresponding to the first light beam portion 7al, which has the first light intensity, and generated by the first shape setting unit 21) is blocked, and the edge shape of the peripheral portion at the -X direction side in the longitudinal direction of the slit shape 20a takes the shape of the edge 23a of the first selection member 23, that is, becomes linear (refer to Fig. 8). Further, the edge shape of the peripheral portion at the -X direction side in the longitudinal direction of the slit shape 20a takes the shape of the peripheral portion 21a set by the first shape setting unit 21 by moving the first selection member 23 in the -X direction relative to the first shape setting unit 21 so that the peripheral portion 21a, which is set by the first shape setting unit 21, is not covered by the first selection member 23 (refer to Fig. 7). In this manner, the first selection member 23 selects between passage and non-passage of the first light beam portion 7a1.

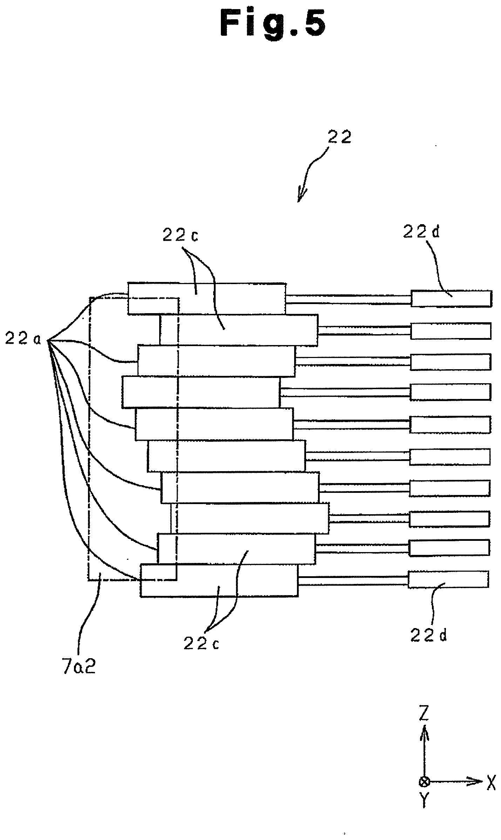

The second shape setting unit 22 and the second selection member 24 are arranged at the +X direction side of the illumination field 7a. Fig. 5 shows the structure of the second shape setting unit 22. As shown in Fig. 5, the second shape setting unit 22 includes a plurality of (ten in the present embodiment) blades 22c to set a second light intensity distribution, which is the light intensity distribution of a second light beam portion 7a2 that passes by the vicinity of a peripheral portion 22a. The plurality of blades 22c are formed by components which completely block light, such as stainless steel components, and are arranged in a comb-tooth pattern, without gaps, along the Z direction within a plane (XZ plane) intersecting the optical axis AX of the illumination light. A drive portion 22d is connected to each blade 22c, and the blades 22c are formed to be independently movable in the X direction when driven by the drive portions 22d. The drive portions 22d are driven and controlled by the controller 11.

The second selection member 24 has a linear edge 24a that extends in the Z direction and is located at the -Y direction side, that is, the light entrance side, of the plurality of blades 22c of the second shape setting unit 22, as shown in Fig. 2. A drive portion 24b is connected to the second selection member 24, and the second selection member 24 is formed to be movable along the X direction when driven by the drive portion 24b. The drive portion 24b is driven and controlled by the controller 11.

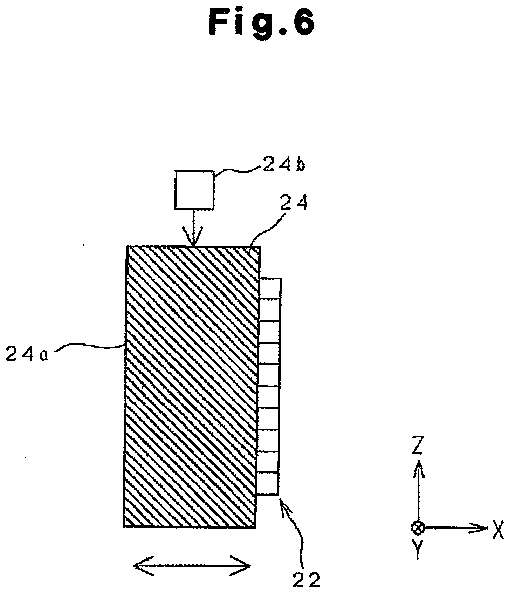

As shown in Fig. 6, the peripheral portion 22a, which is set by the second shape setting unit 22, is covered by the second selection member 24 when the second selection member 24 is moved along the -X direction relative to the second shape setting unit 22. That is, the second light beam portion 7a2, which has the second light intensity distribution set by the second shape setting unit 22, is blocked (more precisely, the entering light beam corresponding to the second light beam portion 7a2, which has the second light intensity, and generated by the second shape setting unit 22), and the edge shape of the peripheral portion on the +X direction side along the longitudinal direction of the slit shape 20a takes the shape of the edge 24a of the second selection member 24, that is, becomes linear (refer to Fig. 7). The edge shape of the peripheral portion at the +X direction side along the longitudinal direction of the slit shape 20a takes the shape of the peripheral portion 22a set by the second shape setting unit 22 by moving the second selection member 24 in the +X direction relative to the second shape setting unit 22 so that the peripheral portion 22a, which is set by the second shape setting unit 22, is not covered by the second selection member 24 (refer to Fig. 8).

The variable slit device 20, for example, forms the shape of the illumination light, that is, the slit shape 20a, in correspondence with an illumination condition for illuminating the mask M. The illumination condition for illuminating the mask M will be described later. When, for example, the first light intensity distribution is set by the first shape setting unit 21 in correspondence with a first illumination condition to illuminate the mask M, the controller 11 moves the first selection member 23 in the -X direction relative to the first shape setting unit 21 and moves the second selection member 24 in the -X direction relative to the second shape setting unit 22. As a result, the variable slit device 20 forms a slit shape 20a (dotted area) as shown in Fig. 7. The slit shape 20a shown in Fig. 7 is defined by the first light beam portion 7al, which is formed by the first shape setting unit 21, and a third light beam portion 7a3. The third light beam portion 7a3 is a light beam portion that is not blocked by the first selection member 23 and the second selection member 24.

When, for example, the second light intensity distribution is set by the second shape setting unit 22 in correspondence with a second illumination condition to illuminate the mask M, the first selection member 23 is moved in the +X direction relative to the first shape setting unit 21, and the second selection member 24 in the +X direction relative to the second shape setting unit 22. As a result, the variable slit device 20 forms a slit shape 20a (dotted area) as shown in Fig. 8. The slit shape 20a shown in Fig. 8 is defined by the second light beam portion 7a2, which is formed by the second shape setting unit 22, and the third light beam portion 7a3.

The first shape setting unit 21 forms the edge shape of the peripheral portion corresponding to a predetermined illumination condition by driving the plurality of blades 21c while the first selection member 23 covers the peripheral portion 21a of the first shape setting unit 21. In the same manner, the second shape setting unit 22 forms the edge shape of the peripheral portion corresponding to a predetermined illumination condition by driving the plurality of blades 22c while the second selection member 24 covers the peripheral portion 22a of the second shape setting unit 22. Therefore, even when the illumination condition is changed, the illumination light can be quickly changed to an illumination distribution that corresponds to the illumination condition.

Returning to Fig. 1, the light beam that has passed through the variable slit device 20 obtains the slit shape 20a, which is set by the variable slit device 20, undergoes a collecting action performed by an imaging optical system 8 and then illuminates in an overlapped manner a mask (illuminated plane) M having a predetermined pattern. The mask M is arranged on a mask stage MS, the coordinates of which are managed by an interferometer IFw, and is movable in the scanning direction (±X direction). The previously mentioned mask blind 7 is arranged at a position optical conjugated with the pattern surface (illuminated plane) of the mask M (position optically conjugated with the wafer W) by the imaging optical system 8. The plurality of blades 21c and 22c of the variable slit device 20 are arranged at positions slightly defocused from the position optically conjugated with the illuminated plane. The light source 1, beam transmission system 2, polarized state changing unit 3, beam shaper 4, micro lens array 5, condenser optical system 6, mask blind 7, variable slit device 20, and imaging optical system 8 form an illumination device.

The light beam, which has passed through the pattern of the mask M, then passes through a projection optical system PL and forms an irradiation region, which corresponds to the slit shape 20a set by the variable slit device 20, on the wafer (substrate) W, which is a photosensitive substrate. The wafer W is placed on the wafer stage WS, the coordinates of which are managed by the interferometer IFw on the wafer side, and is movable within the XY plane as viewed in the drawing. The mask pattern is then transferred and exposed on the wafer W by changing the positional relationship between the irradiation region and the wafer W along a direction (X direction) intersecting the longitudinal direction of the slit shape 20a. That is, the pattern of the mask M is sequentially exposed on each exposure region of the wafer W by a scanning exposure while moving the wafer W in the scanning direction along a plane extending perpendicular to the optical axis AX of the projection optical system PL.

The wafer w is a disk-shaped substrate having a diameter of, for example, 200 mm or 300 mm. A ceramic substrate used for manufacturing a thin film magnetic head or a rectangular flat glass plate having a side or diagonal larger than 500 mm and coated with a photoresist (photosensitive material) for manufacturing a liquid crystal element may also be used as the substrate. In addition to a refractive system, a reflective refractive optical system, or reflective optical system may be used as the projection optical system P1. Further, the projection optical system P1 may be an optical system which forms an intermediate image therein.

The exposure apparatus shown in Fig. 1 is provided with a polarized state measurement device 9, which measures the polarized state of the illumination light on the wafer W, and a light amount detecting unit 10, which detects the amount of the illumination light. The measurement result of the polarized state measurement device 9 and the detection result of the light amount detecting unit 10 are output to the controller 11. The controller 11 controls the operation of the polarized state changing unit 3 based on the measurement result of the polarized state measurement device 9 and controls the output of the light source 1 based on the detection result of the light amount detecting unit 10. The controller 11 controls the operations of the polarized state changing unit 3 and the beam shaper 4 in accordance with the pattern characteristics (fineness, directionality and the like) of the mask M. The controller 11 also sets the slit shape 20a formed by the variable slit device 20 based on the illumination condition, that is, the settings of the polarized state changing unit 3 and the beam shaper 4. In other words, the slit shape 20a formed by the variable slit device 20 is changed to correct the non-uniformity of the integrated exposure light caused by illumination non-uniformity in the illumination light generated by the settings of the polarized state changing unit 3 and the beam shaper 4.

The exposure apparatus of the first example is provided with the variable slit device 20, which includes the first shape setting unit 21 for setting the first light intensity distribution corresponding to the first illumination condition, the second shape setting unit 22, which sets a second light intensity distribution corresponding to a second illumination condition, and the first selection member 23 and second selection member 24, which quickly and easily select the first light intensity distribution and the second light intensity distribution. Thus, an illumination light which has a desired slit shape can be quickly formed to correct illumination non-uniformity in correspondence with the illumination condition, and the pattern on the mask M can be accurately exposed on the wafer W with a high throughput.

Although the first selection member 23 and the second selection member 24 are movable only in the X direction in the variable slit device 20 of the first embodiment. However, in addition to the X direction, at least either one of the first selection member 23 and the second selection member 24 may be configured to be inclinable relative to the Z direction (that is, rotatable about the Y direction (the direction in which the light beam travels)).

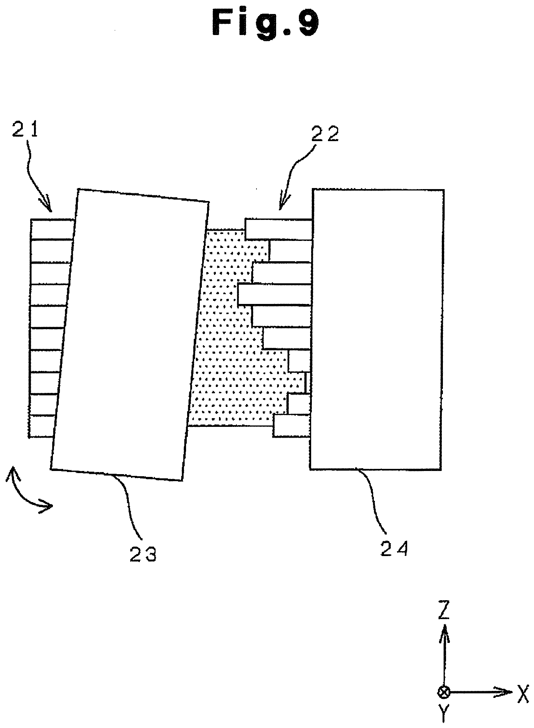

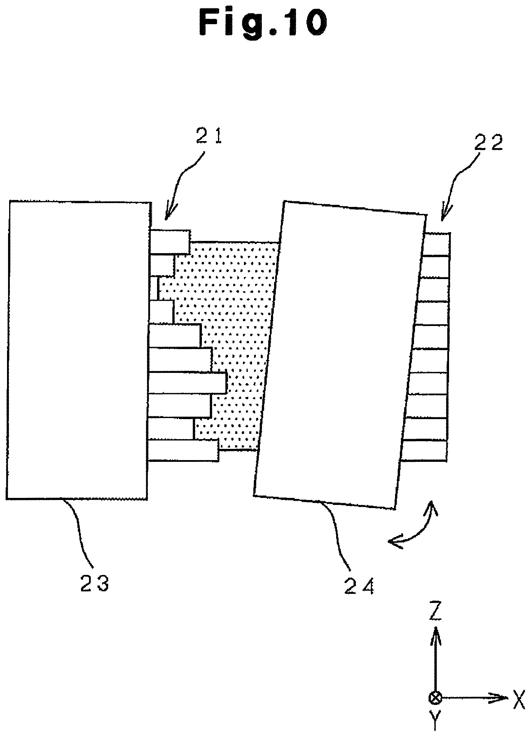

Figs. 9 and 10 show a first modification of the variable slit device of the first example. Fig. 9 shows the first selection member 23 inclined relative to the Z axis, and Fig. 10 shows the second selection member 24 inclined relative to the Z axis. At least one of the first selection member 23 and second selection member 24 may be inclinable relative to the Z direction to correct illumination non-uniformity having a predetermined inclination in the Z direction.

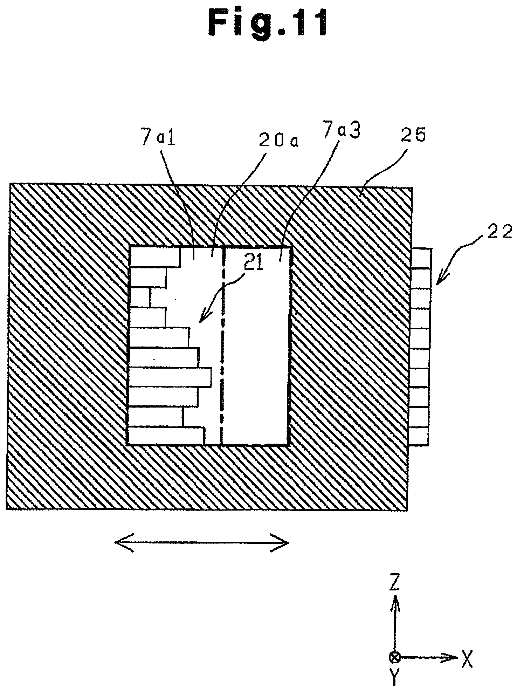

The variable slit device 20 of the first example includes the first selection member 23 and the second selection member 24. However, a selection member 25 may be formed integrally with the first selection member 23 and the second selection member 24, as shown in Fig. 11. The selection member 25 is movable in the X direction so that the peripheral portion 22a (second light beam portion 7a2) set by the second shape setting unit 22 is covered by the selection member 25 and the peripheral portion 21a (first light beam portion 7a1) is not covered by the selection member 25 when moving the selection member 25 in the -X direction. This forms a slit shape 20a as shown in Fig. 11. Furthermore, when moving the selection member 25 in the +X direction, the peripheral portion 22a (second light beam portion 7a2) set by the second shape setting unit 22 is not covered, and the peripheral portion 21a (first light beam portion 7a1) set by the first shape setting unit 21 is covered by the selection member 25. The shape of the slit shape 20a in the longitudinal direction at the -X side therefore takes a linear shape formed by the selection member 25, and the shape of the slit shape 20a in the longitudinal direction at the +X side takes the shape of the peripheral portion 22a set by the second shape setting unit 22. The selection member 25 may also be inclinable relative to the Z axis.

In the variable slit device 20 of the first example, the first selection member 23 and the second selection member 24 move integrally in the X direction relative to the first shape setting unit 21 and the second shape setting unit 22. Instead, the first shape setting unit 21 and the second shape setting unit 22 may be moved integrally in the X direction relative to the first selection member 23 and the second selection member 24. Moreover, at least only one of the first shape setting unit 21, the second shape setting unit 22, the first selection member 23, and the second selection member 24 may be movable in the X direction.

In the variable slit device 20 of the first example, the plurality of blades 21c and 22c are formed by components completely blocking light. Instead, a plurality of blades (light intensity distribution setting unit) may have a concentration distribution (transmittance distribution). In this case, the correction device disclosed in U.S. Patent No. 6,404,499 may be used as the light intensity distribution setting unit having a concentration distribution (transmittance distribution), and a movable element of a light attenuation device disclosed in U.S. Patent Application Publication No. 2005/0140957 may be used as the plurality of blades having a concentration distribution (transmittance distribution).

In the variable slit device 20 of the first example, the plurality of blades 21c are each movable in the X direction. Instead, at least only one of the plurality of blades 21c may be movable. In the same manner, the plurality of blades 22c are each movable in the X direction. Instead, at least only one of the plurality of blades 22c may be movable.

In the variable slit device 20 of the first example, the selection member 23 and the first shape setting unit 21 are arranged sequentially in the optical path from the light source 1. Instead, these components may also be arranged in the order of the first shape setting unit 21 and the selection member 23. In the same manner, the selection member 24 and the second shape setting unit 22 are arranged in this order. Instead, these components may be arranged in the order of the second shape setting unit 22 and the selection member 24.

The imaging optical system may also be arranged between the selection members 23 and 24 and the first and second shape setting units 21 and 22 so that the selection members 23 and 24 are arranged in optical conjugation with the first and second shape setting units 21 and 22.

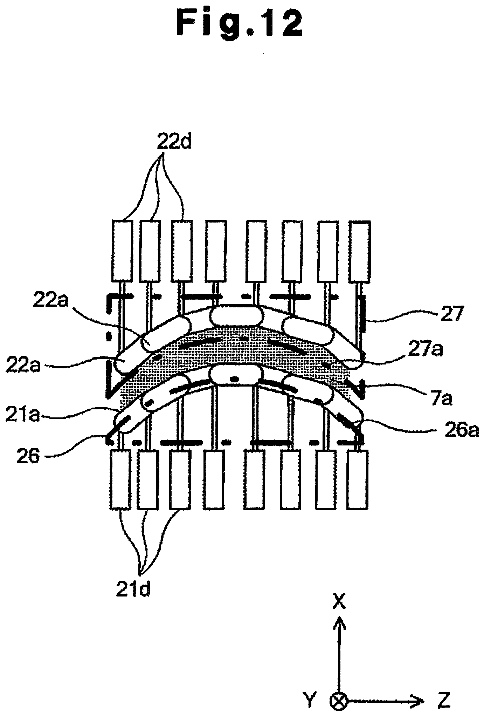

In the illumination device of the first example, a rectangular illumination field 7a is formed by the mask blind 7. Instead, a circular (arcuate) illumination field may be formed in a third modification as shown in Fig. 12. In this case, the first selection member 23 and the second selection member 24, which have linear edges 23a and 24a, must be replaced by a first selection member 26 and second selection member 27, which have circular (arcuate) edges 26a and 27a.

In the first example, the first shape setting unit 21 or the second shape setting unit 22 selects the shape of the slit shape in the longitudinal direction by moving the first selection member 23 and the second selection member 24 in the X direction. Instead, the first shape setting unit 21 or the second shape setting unit 22 may select the shape of the slit shape in the longitudinal direction by moving the optical flux, which enters the variable slit device 20, in the lateral direction of the slit shape. In this case, a condenser plate or optical path deflecting mirror capable of inclining the optical path are arranged in the optical path on the light source side of the variable slit device to shift the light beam by inclining the condenser plate or optical path deflection mirror. The inclinable condenser plate or optical path deflection mirror may be considered to be a selection member.

Two slit shapes are formed in accordance with two illumination conditions in the variable slit device 20 of the first embodiment. Instead, three or more slit shapes may be formed in correspondence with three or more illumination conditions. That is, when the transfer and exposing performed with the illumination light having a first slit shape formed by the first shape setting unit 21 (or the second shape setting unit 22) in correspondence with the first illumination condition, a second slit shape may be formed in correspondence with a second illumination condition by the second shape setting unit 22 (or the first shape setting unit 21) that is covered by the second selection member 24 (or the first selection member 23). Further, when transfer and exposure is performed with the illumination light having a second slit shape, a third slit shape may be formed in correspondence with a third illumination condition by the first shape setting unit 21 (or the second shape setting unit 22) that is covered by the first selection member 23 (or the second selection member 24). In this manner, various slit shapes may be sequentially formed in correspondence with various illumination conditions without reducing throughout.

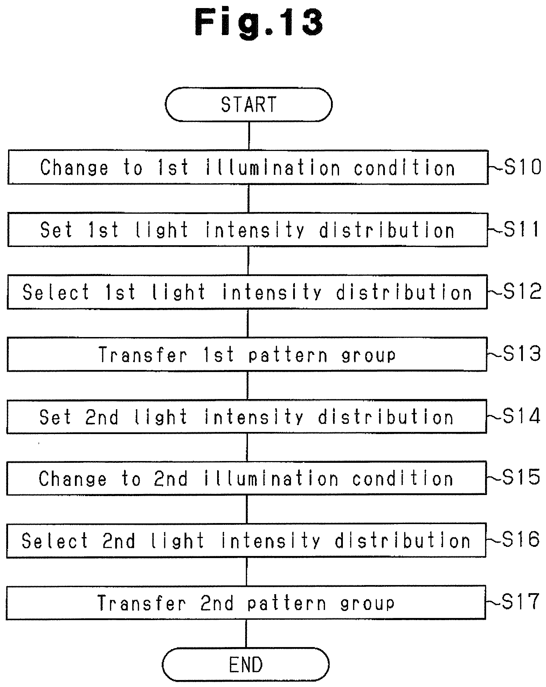

An exposure method according to the invention using the exposure apparatus of the first example will now be discussed with reference to the flowchart of Fig. 13. In the exposure method of the invention, a mask M having a first pattern group formed in a first pattern region and a second pattern group formed in a second pattern region is used to perform double exposure in which the second pattern group is transferred on a wafer W so as to overlap the first pattern group that has already been transferred.

The first pattern group formed in the first pattern region is first transferred onto a wafer W. That is, the controller 11 controls the operations of the polarized state changing unit 3 and the beam shaper 4 based on a first illumination condition corresponding to the line width and directionality of the first pattern group. That is, conditions are changed to the first illumination condition (block S10, illumination condition changing block).

Then, the controller 11 sets the first light intensity distribution, which is the light intensity distribution of the peripheral portion 21a of the first shape setting unit 21, to correct the non-uniformity of the accumulated exposure amount caused by illumination non-uniformity in the illumination light generated under the first illumination condition (block S11, first light intensity distribution setting block). Specifically, the edge shape of the peripheral portion 21a is formed by driving the plurality of blades 21c. In this case, the illumination non-uniformity of the illumination light generated by the first illumination condition are measured beforehand and stored in a storage unit (not shown). The light intensity distribution of the peripheral portion 21a, that is, the amount of movement of each blade 21c, is also calculated beforehand and stored in a storage unit (not shown) to correct the non-uniformity in the accumulated exposure amount stored in the storage unit that is caused by illumination non-uniformity. The light intensity distribution of the peripheral portion 21a, that is, the amount of movement of the plurality of blades 21c, may also be calculated to correct the non-uniformity of the accumulated exposure amount light caused by the illumination non-uniformity from the detection results of the light amount detecting unit 10, which detects illumination non-uniformity in the illumination light generated under the first illumination condition.

Then, the controller 11 then selects the light beam portion (first portion of the light beam), which has the light intensity distribution for the peripheral portion 21a, with the first shape setting unit 21 to correct the non-uniformity in the accumulated exposure amount light caused by the illumination non-uniformity generated by the first illumination condition (block S12, selecting block). Specifically, the peripheral portion 22a of the second shape setting unit 22 is covered by moving the first selection member 23 and the second selection member 24 in the -X direction relative to the first shape setting unit 21 and the second shape setting unit 22 so as to form the edge shape of the peripheral portion at the +X direction side of the slit shape 20a with the shape of the edge 24a of the second selection member 24, that is, with a linear shape. The edge shape of the peripheral portion at the -X direction side of the slit shape 20a is shaped by each blade 21c of the first shape setting unit 21.

The first pattern group, which is illuminated by the illumination light passing through the slit shape 20a formed in block S12, is transferred and exposed onto the wafer W while the mask M and wafer W are scanned in the scanning direction (Y direction) by the exposure apparatus and the projection optical system PL (block S13, first transferring block). While the first pattern group is being transferred and exposed in block S13, the controller 11 executes part of an operation for setting a second light intensity, which is the light intensity distribution of the peripheral portion 22a for the second shape setting unit 22, to correct the non-uniformity of the accumulated exposure amount light caused by illumination non-uniformity in the illumination light generated under the second exposure condition in correspondence with the directionality and line width of the second pattern group (block S14, second light intensity distribution setting block). That is, the edge shape of the peripheral portion 22a is formed by driving the plurality of blades 22c while the second shape setting unit 22 is covered by the second selection member 24. In this case, the illumination non-uniformity of the illumination light generated by the second exposure condition are measured beforehand and stored in a (storage unit). The light intensity distribution of the peripheral portion 22a, that is, the amount of movement of each blade 22c is calculated beforehand and stored in a storage unit (not shown) to correct the non-uniformity of the accumulated exposure amount light stored in the storage device caused by illumination non-uniformity. The light intensity distribution of the peripheral portion 22a, that is, the amount of movement of the plurality of blades 22c, may also be calculated to correct the non-uniformity of the accumulated exposure amount light caused by the illumination non-uniformity from the detection results of the light amount detecting unit 10, which detects illumination non-uniformity in the illumination light generated under the second illumination condition.

After transfer and exposure of the first pattern group has been completed in block S13, the controller 11 controls the polarized state changing unit 3 and the beam shaper 4 to change conditions to the second illumination condition (block S15, illumination condition changing block).

The controller 11 then selects a light beam portion (second portion of the light beam), which has the light intensity distribution for the peripheral portion 22a, with the second shape setting unit 22 to correct the non-uniformity of the accumulated exposure amount light caused by illumination non-uniformity in the illumination light generated under the second illumination condition (block S16, further selecting block). Specifically, the peripheral portion of the first shape setting unit 21 is covered by moving the first selection member 23 in the +X direction relative to the first shape setting unit 21 so as to form the edge shape of the peripheral portion in the -X direction side with the shape of the edge 23a of the first selection member 23, that is, with a linear shape. Simultaneously, the edge shape of the peripheral portion at the +X direction side of the slit shape 20a takes the shape of the peripheral portion 22a of the second shape setting unit 22 by moving the second selection member 24 in the +X direction relative to the second shape setting unit 22. In this manner, the slit shape 20a is formed, and all of the second light intensity distribution setting operation is executed. Next, the second pattern group, which is illuminated by the illumination light passing through the slit shape 20a selected in block S16, is transferred and exposed on the wafer while the mask M and the wafer W are scanned in the scanning direction by the illumination device and the projection optical system PL (block S17, second transferring block). The light beam component, which has the light intensity distribution for the peripheral portion 21a of the first shape setting unit 21, is then selected and the first pattern group is transferred and exposed onto the wafer W in a manner overlapping the second pattern group that has already been transferred. In this manner, the first pattern group and the second pattern group are sequentially overlapped and exposed. The wafer W, which has been subjected to exposure and transfer of the first pattern group and the second pattern group, is then conveyed from the exposure apparatus to a developing device and developed by the developing device (developing process).

According to the exposure method of the invention, when the second light intensity distribution is selected, the slit shape can be quickly changed to a slit shape which has the second light intensity distribution and accurate exposure can be a accomplished with a high throughput because the setting of the second light intensity distribution which corresponds to the second pattern group is executed simultaneously with the transfer of the first pattern group onto the wafer.

Although exposure is accomplished using a mask which has a first pattern group formed in a first pattern region and a second pattern group formed in a second pattern region in the exposure method of the second embodiment, exposure may also be accomplished using masks which separately form the first pattern group and the second pattern group. Although double exposure has been described in the exposure method of the invention, the present invention is applicable to exposures other than double exposure.

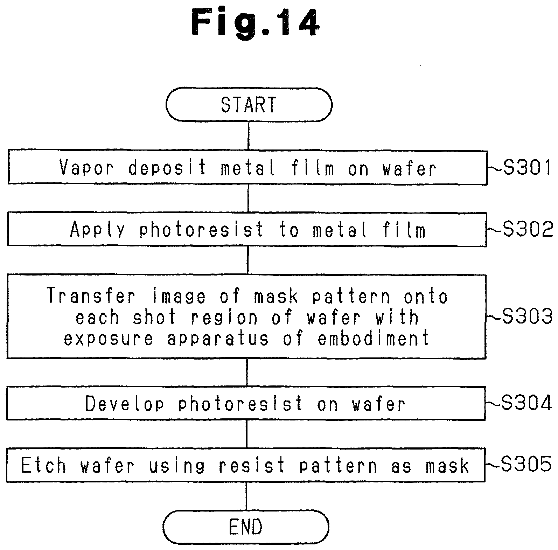

In the exposure apparatus of the first example, a micro device (semiconductor element, photographic element, liquid crystal display element, thin film magnetic head, and the like) can be manufactured by exposing (exposure process) a predetermined pattern onto a photosensitive substrate (wafer) with a projection optical system. An example of a method used to produce a semiconductor device serving as a micro device by forming a predetermined circuit pattern on a photosensitive substrate such as a wafer or the like using the exposure apparatus of the first example is described below as a second example with reference to the flowchart of Fig. 14.

A metal film is first deposited on a wafer through vapor deposition in block S301 as shown in Fig. 14. Photoresist is then applied to the metal film on the wafer in block S302. Thereafter, a first pattern, which is illuminated by illumination light that has a first slit shape formed in correspondence with a first illumination condition, is scanned and exposed on a first shot region on the wafer by a projection optical system in block S303. A second pattern, which is illuminated by illumination light that has a second slit shape formed in correspondence with a second illumination condition that differs from the first illumination condition, is then scanned and exposed in a second shot region on the wafer by the projection optical system. Subsequently, the first pattern, which is illuminated by illumination light that has a first slit shape formed in correspondence with the first illumination condition, is exposed and overlapped with the second shot region that was previously exposed by the second pattern. Further, the second pattern, which is illuminated by illumination light that has a second slit shape formed in correspondence with the second illumination condition, is scanned in a third shot region on the wafer by the projection optical system. Thus, the first pattern and the second pattern are sequentially exposed and overlapped in each shot region.

After the photoresist on the wafer has been developed in block S304, the resist pattern on the wafer is etched as a mask in block S305 to form a circuit pattern corresponding to a predetermined pattern in each shot region on the wafer.

A circuit pattern of an upper layer is further formed. Then, a plurality of devices are cut out from the wafer to manufacture semiconductor element devices or the like. In the above semiconductor device manufacturing method, highly accurate semiconductor devices are manufactured with a high throughput since exposure is performed using the exposure apparatus of the previously described embodiment. Various processes of depositing a metal film on a wafer, applying a resist to the metal film, and then performing exposure, development, and etching in blocks S301 through S304. However, it is obvious that prior to these processes, various processes can be performed such as forming a silicon oxide film on the wafer and applying a resist to the silicon oxide film and then performing exposure, development, and etching.

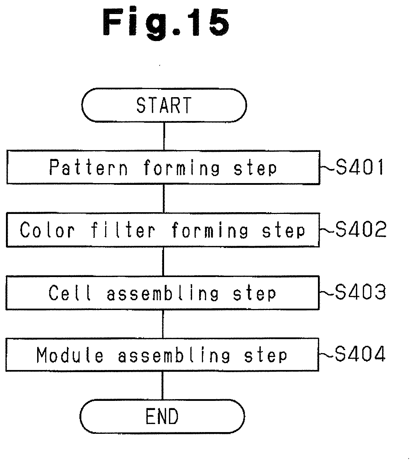

In the exposure apparatus of the first example, a flat panel display (typically, a liquid crystal display element) can be obtained as a micro device by forming a predetermined pattern (circuit pattern, electrode pattern or the like) on a plate (glass substrate). An example of a method used to obtain a liquid crystal element as a flat panel display is described below as a third example with reference to the flowchart of Fig. 15. First, in a pattern forming block S401 in Fig. 15, a so-called photolithography process is executed to transfer and expose a mask pattern onto a photosensitive substrate (resist-coated glass substrate or the like) using the exposure apparatus of the above example. That is, a first pattern, which is illuminated by illumination light that has a slit shape formed in correspondence with a first illumination condition, is scanned and exposed in a first region on a photosensitive substrate by a projection optical system. Then, a second pattern, which is illuminated by illumination light that has a slit shape formed in correspondence with a second illumination condition, is scanned and exposed in a second region on the photosensitive substrate by the projection optical system. The first pattern is then exposed on the second region to overlap the second pattern, and the second pattern is scanned and exposed in a third shot region on the photosensitive substrate. In this manner, the first pattern and the second pattern are sequentially exposed in an overlapped manner. The photolithography process forms predetermined patterns that include a plurality of electrodes or the like on the photosensitive substrate. The exposed substrate is then subjected to a developing process, etching process, a resist removal process, and the like to form a predetermined pattern on the substrate and subsequently proceeds to a color filter forming block in block S402.

In the color filter forming block S402, a color filter is formed by an array of sets of three dots corresponding to R (red), G (green, and B (blue) arranged in a matrix, or an array of a plurality of three stripe filters for R, G, and B arranged in a horizontal scanning direction. After the color filter forming block S402, a cell assembling block S403 is performed. In the cell assembling block S403, a liquid crystal panel (liquid crystal cells) is assembled using the substrate with a predetermined pattern obtained in the pattern forming block S401 and the color filter and the like obtained in the color filter forming block S402. In the cell assembling block S403, a liquid crystal panel (liquid crystal cell) is manufactured by, for example, charging liquid crystal between the substrate, which has the predetermined pattern obtained in the pattern forming block S401, and the color filter, which is obtained in the color filter forming block S402.

Thereafter, in a module assembling block S404, the liquid crystal display element is completed by mounting various components such as a backlight and electric circuits to operate the display of the assembled liquid crystal panel (liquid crystal cells). According to this method of manufacturing a liquid crystal display element, a highly accurate liquid crystal display element can be manufactured with a high throughput because exposure is performed using the exposure apparatus of the above examples and invention.

Although the exposure method of the invention has been described by way of example with multiple exposure, the present invention may be applied to exposures other than multiple exposures.

For example, when exposing a pattern in a plurality of sections (shot regions) on the wafer W, and the distribution of line width uniformity in the shot regions (line width variations in the shot regions) may differ depending on the position of the shot region on the wafer W.

Since there is a correlation between a change in line width of the transferred pattern and a change in the exposure amount during pattern transfer, the line width uniformity within a shot region can be changed locally to obtain line width uniformity (variations in line width within a shot region) of a predetermined distribution (typically, uniform) by locally changing the distribution of the accumulated exposure amount within the shot region (by exposing the shot region with exposure light of a predetermined exposure amount distribution).

Variations in the distribution of line width uniformity within a shot region depending on the position of the shot region on the wafer W may be caused by factors that arise in the exposure apparatus, factors that arise in a processes other than the exposure by the exposure apparatus, or factors that arise in the wafer (typically, wafer flatness).

First, an exposure method which corrects the distribution of variations in line width uniformity within a shot region caused by the exposure apparatus will be described as a fourth example. In this example, a wafer W is subjected to exposure using the exposure apparatus of the first embodiment.

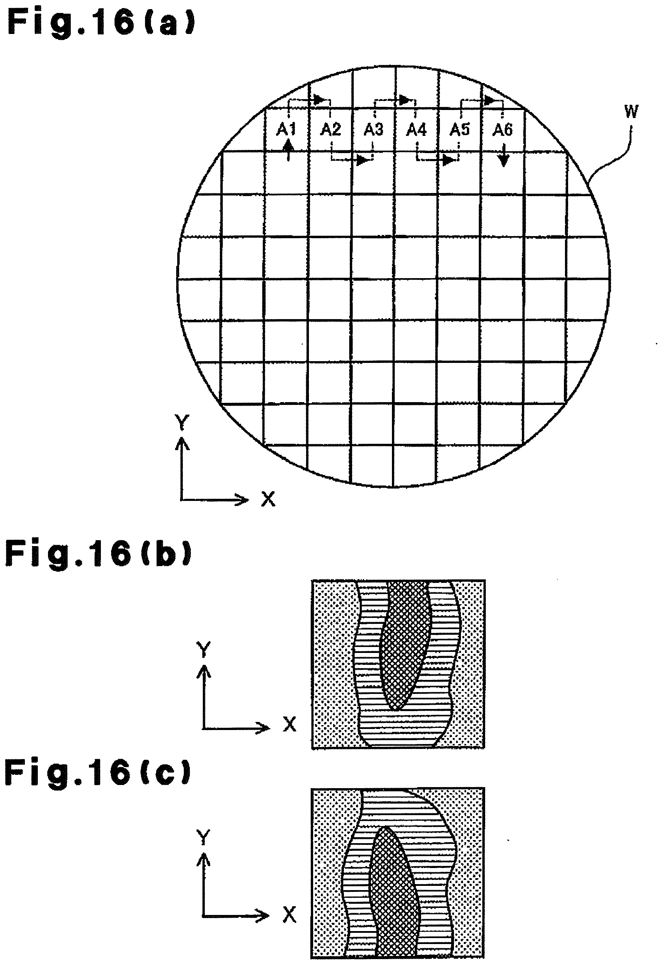

Fig. 16(a) shows a shot array on a wafer w in the fifth embodiment. In Fig. 16(a), a plurality of shot regions (representatively indicated by shot regions A1 to A6) are formed at a predetermined pitch in the X direction and the Y direction on the wafer W.

As indicated by the arrows in Fig. 16(a), after the exposure apparatus exposes the wafer W at the shot region A1 while the wafer W is moved (scanned) in the -Y direction, the wafer W undergoes stepping in the -X direction. Then, the wafer W is exposed at the shot region A2 while the wafer W is moved (scanned) in the +Y direction. In the same manner, exposure is performed at the remaining shot regions while the wafer W is moved (scanned) in the +Y direction or -Y direction.

When variations in a synchronism accuracy error of a reticle and wafer occur depending on the scanning direction (+Y direction, -Y direction), the distribution of line width uniformity in the shot regions A1, A3, and A5, which are exposed by performing scanning in the -Y direction, differs from the distribution of line width uniformity in the shot regions A2, A4, and A6, which are exposed by performing scanning in the +Y direction. Fig. 16(b) shows the distribution of line width uniformity in shot regions A1, A3, and A5, and Fig. 16(c) shows the distribution of line width uniformity in shot regions A2, A4, and A6.

In the exposure method of the fourth example, the distribution of the accumulated exposure amount can be switched (the illumination variation correction state can be switched) in accordance with the forward and reverse scanning directions to prevent fluctuations in the distribution of the line width uniformity depending on the forward and reverse scanning directions, for example, by covering the second shape setting unit with the second selection member 24 while setting the first light intensity distribution with the first shape setting unit 21 when the shot region A1, A3, and A5 are scanned and exposed by moving the wafer W in the -Y direction, and by covering the first shape setting unit with the first selection member 23 while setting the second light intensity distribution with the second shape setting unit 22 when the shot regions A2, A4, and A6 are scanned and exposed by moving the wafer W in the -Y direction.

The operation of switching between the first and second selection members can be performed during the stepping operation. Line width uniformity of each shot region can thus be improved while maintaining a high throughput without any restrictions by the time for the operation of switching the distribution of the accumulated exposure amount (switching of illumination variation correction state).

In the fourth example, since variations in the distribution of the line width uniformity in accordance with the forward and reverse scanning direction can be considered as a systematic error component which is not dependent on the wafer, the driven amount of each blade 21c and 22c for each shot region is constant for at least one lot process.

For example, when the synchronization state or defocus state varies depending on the position of a shot region in the wafer W, the distribution of line width uniformity may vary at each shot region position in the wafer W.

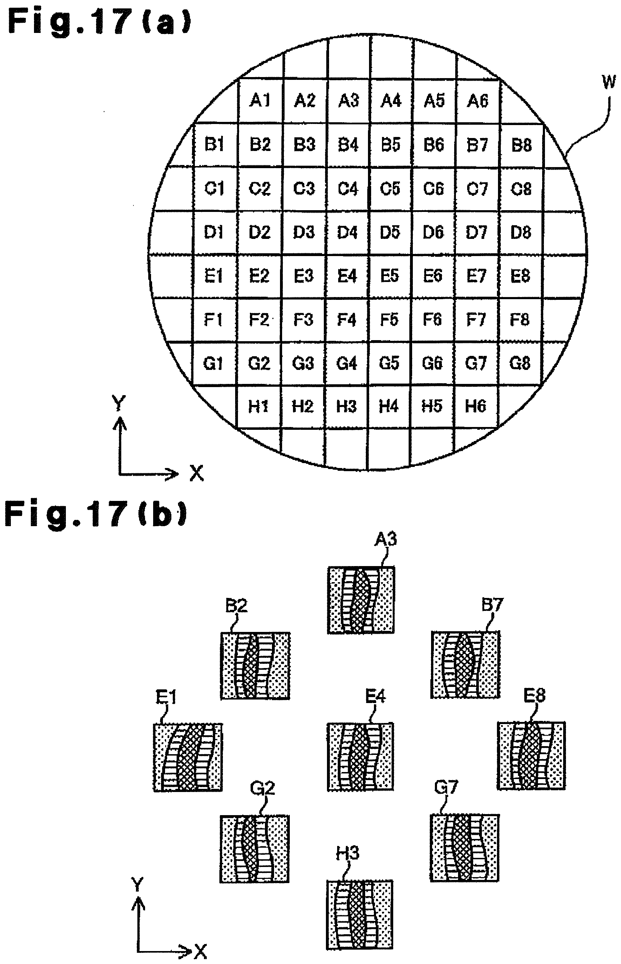

A fifth example of an exposure method which corrects variations in the distribution of the line width uniformity in the shot regions caused by the exposure apparatus will now be described below with reference to Fig. 17. In the sixth embodiment, the wafer W is exposed using the exposure apparatus of the first embodiment. Fig. 17(a) shows a shot array on the wafer W, and Fig. 17(b) shows the state of line width uniformity in the shot regions.

In Fig. 17(a) a plurality of shot regions (represented by A1 to H6) are formed on the wafer W at a predetermined pitch in the X direction and the Y direction. In this case, for example, as shown in Fig. 17(b), the state of line width uniformity is differs between the shot regions (representatively indicated by regions A3, B2, E1, E4, E8, G2, G7, and H3).

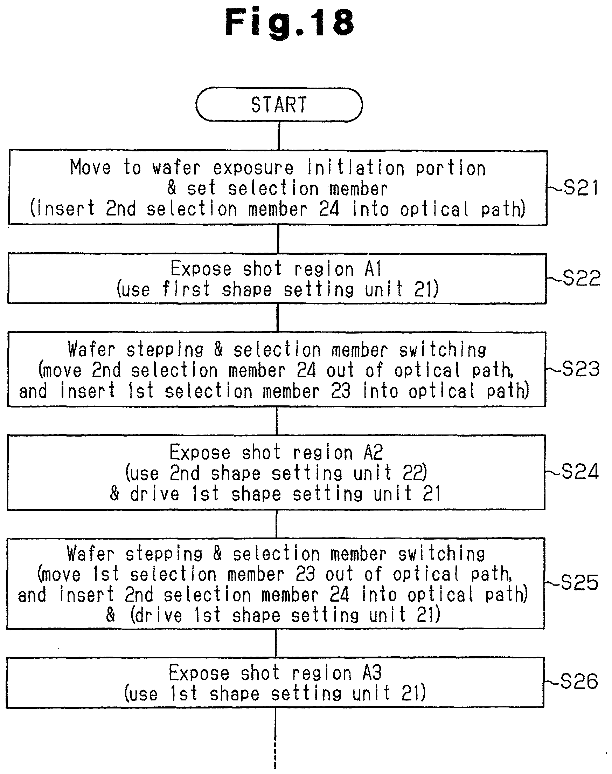

An example of the procedures carried out in the exposure method of the sixth embodiment will now be described with reference to the flowchart of Fig. 18.

Prior to the exposure procedures described below, the distribution of line width uniformity is measured for each shot region in the wafer W, and the drive amount is calculated for each of the blades 21c and 22c in the variable slit device 20 to eliminate variations in the distribution of the line width uniformity and obtain a uniform distribution. In the sixth embodiment, the drive amount of each of the blades 21c and 22c for each shot region is constant for at least one lot process since variations in the distribution of the line width for each shot region position in the wafer W can be considered as a systematic error component which is not dependent on the wafer.

The wafer w is first moved to a wafer exposure initiation position. At this time, the shape of the peripheral portion 21a is set by the plurality of blades 21c of the first shape setting unit 21, the shape of the peripheral portion 22a is set by the plurality of blades 22cj of the second shape setting unit 22, and the second shape setting unit 22 is covered by the second selection member 24 (block S21).

The shot region A1 is then exposed to illumination light, which has a first slit shape formed by the first shape setting unit 21 (block S22).

After the exposure of the shot region A1 is completed, the wafer W undergoes stepping in the -X direction and is positioned at a wafer exposure initiation position for the shot region A2. During the stepping operation, a selection member switching operation is performed to insert the first selection member 23 into the illumination optical path to cover the first shape setting unit 21 and move away the second selection member 24 from the illumination optical path (block S23).

The shot region A2 is then exposed to illumination light, which has a second slit shape formed by the second shape setting unit 22. During the exposure operation, the blades 21c of the first shape setting unit 21 are driven based on drive amount information of each blade 21c to eliminate variations and obtain uniform line width distribution for the shot region A3 (block S24).

After the exposure of the shot region A2 has been completed, the wafer W undergoes stepping in the -X direction and is positioned at a wafer exposure initiation position for the shot region A3. During the stepping operation, a selection member switching operation is performed to insert the second selection member 24 into the illumination optical path to cover the second shape setting unit 22 and move away the second selection member 23 from the illumination optical path. When the drive operation performed on the blades 21c of the first shape setting unit 21 in block S24 is not be completed during the exposure operation of the shot region A2, the operation may continue during the stepping operation (block S25).

The shot region A3 is then exposed to illumination light, which has the first slit shape formed by the first shape setting unit 21 (block S26).

Although not shown in Fig. 18, hereinafter, the operations described above are repeated until completing exposure of all the shot regions on the wafer W.

In this manner, in the fifth example, the operation for changing the peripheral portions 21c and 21c of the first shape setting unit 21 and the second shape setting unit 22 may be performed during at least either one of the exposure operation and the stepping operation, and the switching operation of the first and second selection members may be performed during the stepping operation. As a result, the line width uniformity is improved in each shot region while maintaining a high throughput without any restrictions by the time for the operation of switching the distribution of the accumulated exposure amount (switching of illumination variation correction state)

In a photolithography process that is performed when manufacturing a semiconductor device, after forming a photoresist (photosensitive material) film on the surface of a processed body such as a substrate, a circuit pattern is exposed on the film, and a resist pattern is formed by developing the exposed photoresist. The photolithography process is performed by a coating-developing device (coater-developer), which includes a resist coating unit for applying resist to a wafer and a development unit for developing the wafer, and an exposure apparatus, which is formed continuously and integrally with the coating-developing device.

Such a coating-developing device includes, for example, a heating unit and a cooling unit to perform a heating process and a cooling process on the wafer after forming the resist film on the wafer or before and after the developing process. The thickness of the resist film on the wafer surface may not be uniform, and the distribution of the heat within the wafer surface may not be uniform during the heating process. In such cases, the distribution of the line width uniformity in the shot region may differ depending on the position of the shot region on the wafer W.

When the temperature distribution of the wafer surface is not uniform in an etching device which etches an etching film, which is an underlying layer of the resist pattern that functions as a mask, the distribution of the line width uniformity in the shot regions may differ depending on the position of the shot region on the wafer W.

Such variations in the distribution of the line width uniformity in the shot regions that depend on the position of the shot region on the wafer are caused by the coating-developing device or the etching device and include a somewhat stable error distribution (systematic error distribution) that is not dependent on the shot position on the wafer.

An exposure method, which corrects variations in the distribution of the line width uniformity caused by a process other than the exposure process performed by the exposure apparatus, will now be described below as a sixth example. In this example, the wafer W is exposed using the exposure apparatus of the first example.

The shot array on the wafer W in the seventh embodiment is identical to that in the sixth embodiment shown in Fig. 17(a) and thus will not be described.

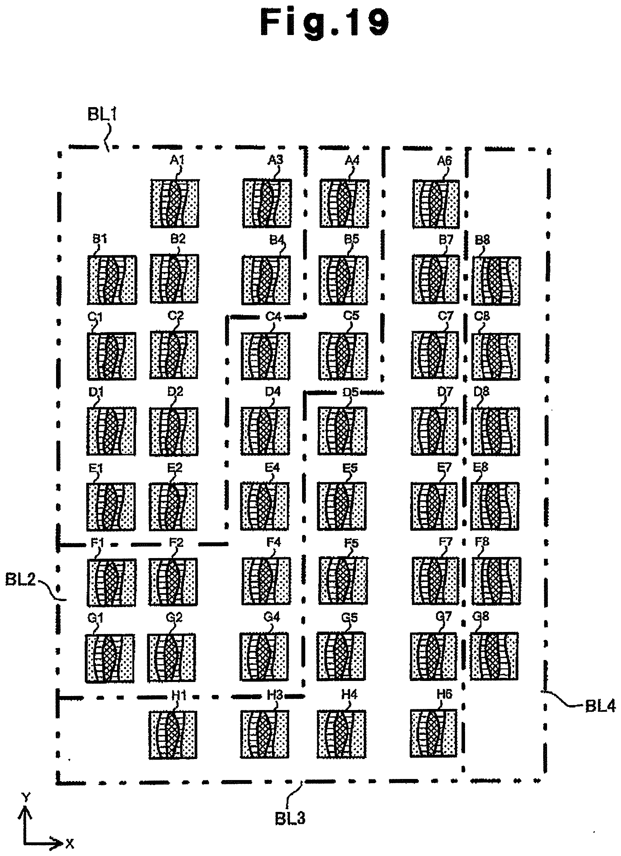

Fig. 19 shows the distribution of variations in the line width uniformity caused by a process other than the exposure process for each of a plurality of shot regions. In the seventh embodiment, the plurality of shot regions in the wafer W are divided into a plurality of groups BL1 to BL4 so that shot regions having the same tendency in the distribution of variations in the line width uniformity are in the same group. The distribution of the accumulated exposure amount during exposure for each shot regions is the same in each group.

For example, when the plurality of shot regions A1 to H6 are exposed on the wafer W, the shot regions A1 to H6 having substantially the same accumulated exposure amount distribution form the same group.

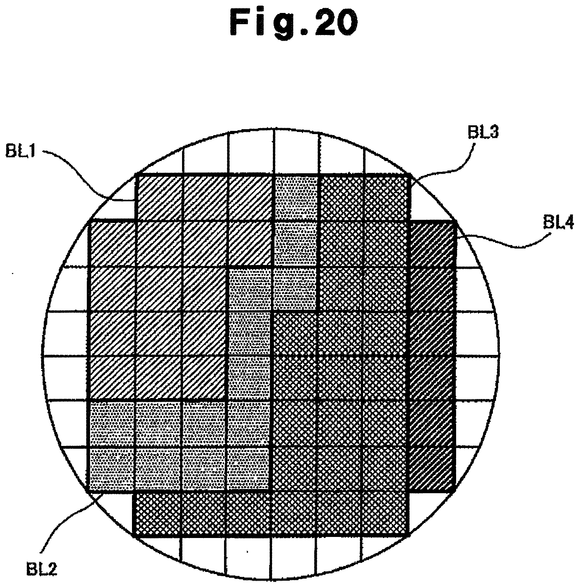

In the sixth example, as shown in Fig. 20, the shot regions A1∼A3, B1∼B4, C1∼C3, D1∼D3, and E1∼E3 form a first group BL1. The shot regions A4, B5, C4∼C5, D4, E4, F1∼F4, and G1∼G4 form a second group BL2. The shot regions A5∼A6, B6∼B7, C6∼C7, D5∼D7, E5∼E7, F5∼F7, G5∼G7, and H1∼F6 form a third group BL3. The shot regions B8, C8, D8, E8, F8, and G8 form a fourth group BL4.

The accumulated exposure amount distribution being substantially the same refers to the accumulated exposure amount distribution being such that variations in the required line width uniformity for the shot regions is within a tolerable range.

Next, the drive amount of the plurality of blades 21c and 22c of the variable slit device 20 is obtained based on the information of the accumulated exposure amount distribution in each group BL1 through BL4.

Thereafter, exposure is performed on the plurality of shot regions of the wafer W.

Although description is given on the exposure procedures for the shot regions A1 to A6 among the plurality of shot regions A1 to H6 shown in Fig. 17(a) (or Fig. 20), exposure is performed in the same manner on the other shot regions B1 to H6.

The wafer stage, which holds the wafer W, is first moved to an exposure initiation position for the shot region A1. At this time, the edge shape of the peripheral portion 21a is set to a first shape by driving the plurality of blades 21c in the first shape setting unit 21 of the variable slit device 20 in accordance with a calculated drive amount. The first selection member 23 is then moved away from the illumination optical path, and the peripheral portion 22a of the second shape setting unit 22 is covered by the second selection member 24.

After setting the variable slit device 20, the shot regions A1 through A3 are exposed. During the exposure operation, the shape of the peripheral portion 22a is set to a second shape by driving the plurality of blades 22c in the second shape setting unit 22 covered by the second selection member 24 in accordance with a calculated drive amount.

After the shot region A3 is exposed and during an operation for moving the wafer stage to an exposure initiation position for the shot region A4, the first selection member 23 is moved to cover the peripheral portion 21a of the first shape setting unit 21, and the second selection member 24 is moved out of the illumination optical path.

Thereafter, the shot region A4 is exposed. During the exposure operation, the shape of the peripheral portion 21a is set to a third shape by driving the plurality of blades 21c in the first shape setting unit 21 covered by the first selection member 23 in accordance with the drive amount calculated in block S24.

After the shot region A4 is exposed, the wafer stage is moved to the exposure initiation position for the shot region A5. During this operation, the first selection member 23 is moved out of the illumination optical path, and the second selection member 24 is moved to cover the peripheral portion 22a of the second shape setting unit 22.

Then, the shot regions A5 and A6 are exposed, and the wafer stage is moved to the exposure initiation position for the shot region B8. Such operations are repeated until the exposure of all shot regions on the wafer W is completed.

In this manner, the line width in each shot is optimized while maintaining throughput during the exposure of each shot region by switching correction conditions of the variable slit whenever there is a change in the group to which a shot region belongs.

In the sixth example, the following procedures may be performed when measuring variations in the distribution of line width uniformity in a shot region that depend on the position of a shot region on the wafer caused by the coating-developing device and the etching device.

First, a test wafer is coated (and pre-baked if necessary) using a coater-developer, which is inline-connected to the exposure apparatus, and a test exposure of a test pattern (or actual pattern) is performed. Subsequently, the resist is developed (and baked if necessary) using the coater-developer. The distribution of the line width uniformity of the developed resist pattern is measured for each shot region.

When measuring a line width uniformity error caused by nonuniform etching, a thin film forming process and an etching process may be added to the procedures described above, and the distribution of the line width uniformity of the etched pattern may be measured for each shot region.

The error correction of the line width uniformity caused by processes that are not related to the exposure apparatus may be combined with the error correction of the line width uniformity caused by the exposure apparatus.

When the distribution of the line width uniformity within a shot region, which is dependent on the position of the shot region on the wafer and caused by the coating-developing device or the etching device, varies within a short period (for example, within one lot), a measurement device may be incorporated in a processing device such as the coating and developing device and etching device so as to change the accumulated exposure amount distribution of the exposure apparatus based on the measurement result information from the incorporated measurement device.

The measurement device may be a film thickness measurement device, a scatterometer, or a temperature measurement device, which measures the temperature distribution or history of temperature distribution in a heating unit of the processing device.

When a film thickness measurement device is incorporated in the processing device, the distribution of a resist film thickness or anti reflection coating (BARC) thickness is measured by the film thickness measurement device for each wafer or for every predetermined one of wafers in a single lot. The measurement results are used to calculate the influence on line width uniformity within the wafer surface, and the drive correction amount of each blade in the variable slit device is calculated to correct the influence.

When a scatterometer is incorporated in the processing device, the scatterometer measures the state of the line width uniformity, and the measurement result is used to calculate the drive correction amount of each blade in the variable slit device.

When a temperature measurement device is incorporated in the heating unit of the processing device, the history (change over time) of temperature distribution in the surface of the wafer is measured, and the measurement result is used to calculate the influence on the line width uniformity within the surface of the wafer, and the drive correction amount for each blade in the variable slit device is calculated to correct the influence.

The information from the measurement device incorporated in the processing device may be transmitted to the exposure apparatus directly from the measurement device or through a host computer of a semiconductor manufacturing plant. Furthermore, the calculation of the drive correction amount for the variable slit device may be performed in the exposure apparatus or by a host computer of a semiconductor manufacturing plant.

The factors for wafer flatness will now be discussed.

When the wafer flatness is poor, the distribution of defocus residue differs between positions in a shot region on the wafer W. If there is a defocus residue when a pattern image is exposed, the line width of the transferred pattern image differs from the line width for a best focus state in accordance with the amount of defocus residue. This adversely affects the line width uniformity.

Distribution of the defocus residue is the distribution of the difference between a height distribution within a shot region using a plane obtained by performing fitting on one shot region and a height distribution in the optical axis direction of a pattern image plane using a plane (optimum focal plane) obtained by performing fitting on pattern image plane formed by the projection optical system.

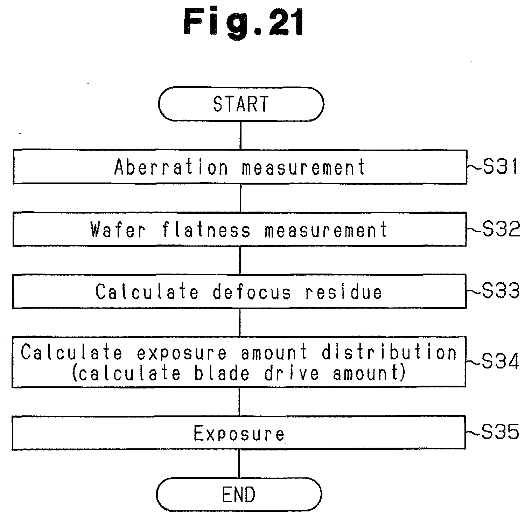

An example of an exposure method for performing exposure while reducing adverse influence on the line width uniformity caused by wafer flatness will now be discussed as a seventh example with reference to the flowchart of Fig. 21. In the exposure method of this example, the variable slit device of the first example is applied to an exposure apparatus including a twin stage as disclosed in European Patent Publication No. 1037117 or U.S. Patent No. 6,208,407.

The distribution of the previously mentioned defocus residue may be calculated from the measurement result of the flatness of a wafer, which serves as an exposed substrate, and the measurement result of the imaging capability (typically, aberration) of a projection optical system.

First, the aberration of a projection optical system is measured using an aberration measurement device disclosed in, for example, U.S. Patent Application Publication No. 2006/0170891 (block S31). If aberration changes of the projection optical system are such that they can be ignored, the aberration measurement does not need not be performed each time an exposure operation is performed and may rather be performed at specific intervals (typically, in each wafer process for a single lot).

A wafer is then mounted on a measurement stage, and the wafer flatness is measured (block S32). The measurement operation of the wafer flatness may be performed at the same time as block S21.

The distribution of the defocus residue in each of the plurality of shot regions on the wafer is calculated from the measurement results of blocks S31 and S32 (block S33).

The influence on variations in the line width in the shot region is determined from the actual exposure condition and the distribution of the defocus residue.

Accordingly, in the present example, the accumulated exposure amount distribution required to obtain a substantially constant line width uniformity for the shot regions may be calculated for each of the shot regions (plurality of sections) on the wafer W from exposure conditions such as the information of the resist (photosensitive material) applied to the wafer W, the illumination condition, the number of apertures in the projection optical system and the like and from the distribution of the defocus residue in each shot region calculated in block S23. The information is then stored in a storage unit (not shown) (block S34).

For example, the pattern type (line-and-space, contact hole, isolated line), the pattern density distribution on the mask, and the size may be used as the pattern information formed by the mask M. The resist type, structure (monolayer, multilayer, top-coated) and film thickness may be used as the information of the photosensitive material. The illumination light angular distribution (corresponding to the pupil brightness distribution at the pupil position of the illumination optical system), illumination light polarization distribution, and reference exposure amount may be used as the illumination condition.

The drive amount of the plurality of blades in the variable slit device can be determined based on the information of the accumulated exposure amount distribution for each shot region.

Then, the plurality of shot regions on the wafer W are exposed (block S35).

Among the plurality of shot regions A1 through H6 shown in Fig. 18(a), the procedures for exposing the shot regions A1 to A6 is described here. However, the other shot regions B1 to H6 may be exposed in the same manner.

In this manner, the line width of each shot region is optimized while maintaining throughput by switching the variable slit correction condition at high speeds whenever exposing a shot region.

When the wafer flatness has the same tendency in the same lot, the flatness measurement result of the first wafer in the lot may be used as a representative value.

Information of the accumulated exposure amount distribution for each shot is used in the eighth embodiment. However, the plurality of shot regions in the wafer may be divided into groups, and the information of the accumulated exposure amount distribution for each group may be used, as in the seventh embodiment.

The slit shape is unchanged when a single shot region is exposed in the variable slit device of the above embodiments. However, the slit shape may be changed when exposing a single shot region. In this case, the slit shape may be formed simultaneously with the peripheral portion 21a and the peripheral portion 22a using both of the first shape setting unit 21 and the second shape setting unit 22. This allows the drive stroke of the plurality of shape setting units to be shortened and enables the setting of a variation correction condition at high speeds.

Although the accumulated exposure amount distribution is controllable in a direction intersecting the scanning direction in the variable slit device of the above embodiments, the illumination light entering the variable slit device or the amount of exposure light reaching the shot region of the wafer may be changed while scanning and exposing a single shot region when the accumulated exposure amount distribution must be controlled in the scanning direction.

In the variable slit device of the above embodiments, the first selection member 23 (26) and the second selection member 24 (27) may also be used as a movable blind of the mask blind 7.

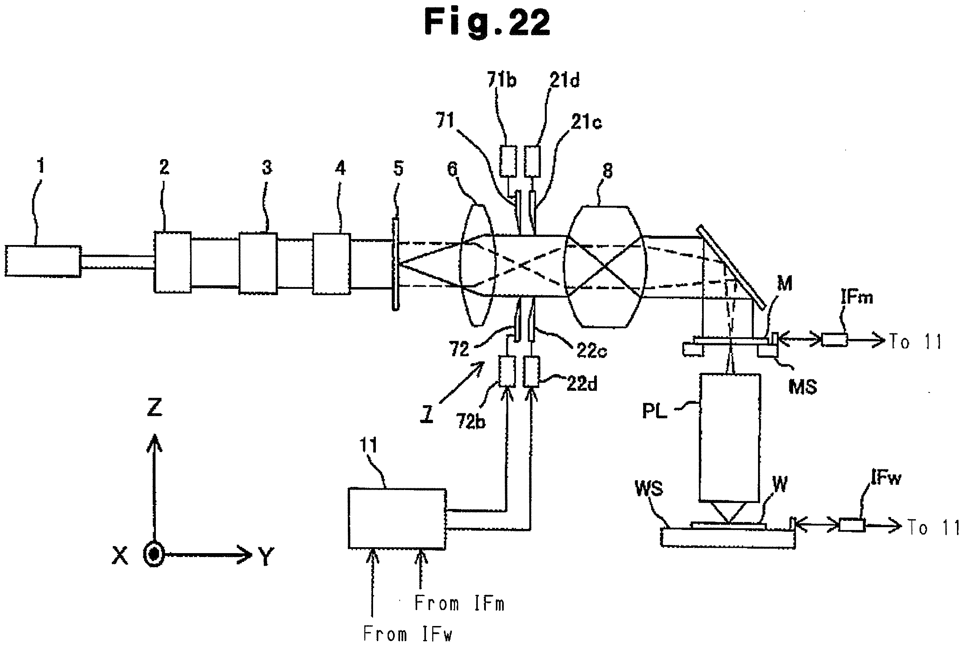

An exposure apparatus in which the first selection member and the second selection member both use a movable blind with the mask blind is described below as an eight example Fig. 22 shows the structure of the exposure apparatus in the eigth example. In the following description, for the sake of brevity, components having the same functions as those of the first embodiment are denoted with the same reference numbers and will not be described. In the ninth embodiment, the moving direction (scanning direction) of the mask M and the wafer W is set to the Y axis direction.

In Fig. 22, the mask blind 7 includes vanes 71 and 72, which set the illumination region in the scanning direction of the mask M and which are arranged within a plane that is the optically conjugated to the pattern forming plane of the mask M in the imaging optical system 8. The vanes 71 and 72 are arranged with the optical axis of the illumination device located in between in the Z direction and are each movable along the Z direction.

The mask blind 7 includes a drive unit 71b, which moves the vane 71 in the Z direction, and a drive unit 72b, which moves the vane 72 in the Z direction. The movement of the vanes 71 and 72 by the drive units 71b and 72b is controlled by output from the controller 11. The vanes 71 and 72 can be considered as a first selection member and a second selection member.

The blades 21c and 22c of the first shape setting unit 21 and the second shape setting unit 22 are arranged within a defocused plane spaced by a predetermined distance from the plane optically conjugated to the pattern forming plane of the mask M. The structure and operation of the first shape setting unit 21 and the second shape setting unit 22 are the same as in the first embodiment and thus will not be described.

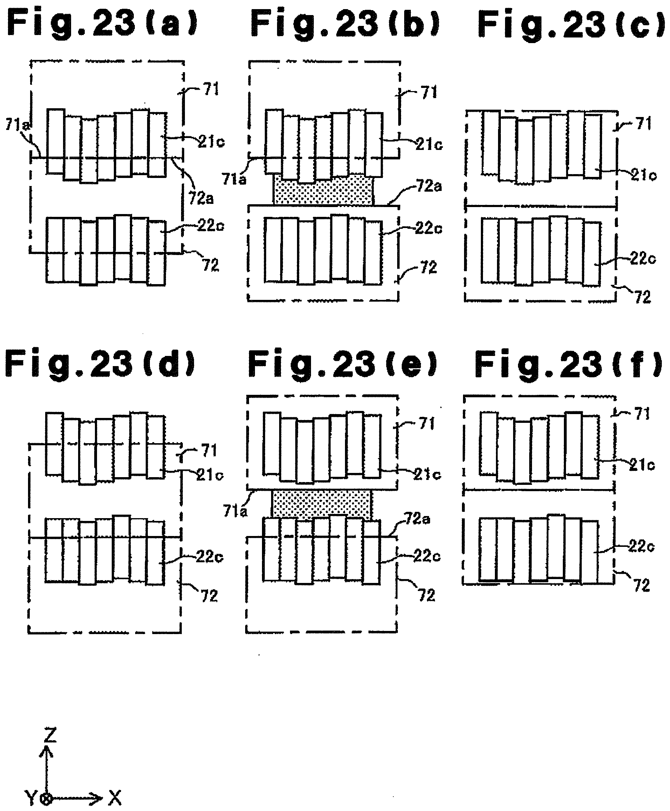

The operation of the vanes 71 and 72 of the mask blind 7 in the exposure apparatus of the ninth embodiment will now be described with reference to Fig. 23. Fig. 23 is a view taken from the Y direction side and shows the vanes 71 and 72 of the mask blind 7, the first shape setting unit 21, and second shape setting unit 22 in the exposure apparatus of the ninth embodiment.

In Figs. 22 and 23 showing the ninth example, the imaging optical system 8 and optical path deflection mirror are arranged between the mask M and the mask blind 7 (first shape setting unit 21 and second shape setting unit 22). Thus, the +Z direction at the position of the mask blind 7 (positions of the first shape setting unit 21 and the second shape setting unit 22) corresponds to the +Y direction at the position of the mask M, and the -Z direction at the position of the mask blind 7 (positions of the first shape setting unit 21 and the second shape setting unit 22) corresponds to the -Y direction at the position of the mask M.

Fig. 23(a) is a diagram showing the positional relationship of the vanes 71 and 72 and the first and second shape setting units 21 and 22 before exposure of a specific shot region on the wafer W (hereafter referred to as the "first shot region"). An edge 71a of the vane 71, which functions as a first selection member, and an edge 72a of the vane 72, which functions as a second selection member, are in an aligned state to form a boundary line. At the moment exposure starts, a light blocking area (restriction area) on the mask M is optically aligned with the boundary line of the edges 71a and 72a (the image of the boundary line is formed on the light blocking area).

Fig. 23(b) is a diagram showing the positional relationship between the vanes 71 and 72 and the first and second shape setting units 21 and 22 when scanning and exposing the first shot region. When scanning and exposing the first shot region, the peripheral portion of the second shape setting unit 22 is covered by the vane 72, and the peripheral portion of the first shape setting unit 21 is not covered by the vane 71. Thus, the light beam, of which edge shape is defined by the peripheral portion set by the first shape setting unit 21 and the linear edge 72a of the vane 72, is directed to the mask M and the wafer W.

The movement of the vane 71 of the mask blind 7 in the -Z direction starts when the light beam reaches the end of the pattern region on the mask M in the +Y direction. At this time, the vane 71 moves simultaneously with the mask M so that the image of the edge 71a of the vane 71 is aligned with the light blocking area on the mask M in the +Y direction.

Fig. 23(c) is a diagram showing the positional relationship between the vanes 71 and 72 and the first and second shape setting units 21 and 22 when the exposure of the first shot region is completed. In this case, the edge 71a of the vane 71, which functions as a first selection member, and the edge 72a of the vane 72, which functions as a second selection member, are aligned to form a boundary line.

Fig. 23(d) is a diagram showing the positional relationship between the vanes 71 and 72 and the first and second shape setting units 21 and 22 before another shot region (hereafter referred to as the "second shot region"), is exposed next.

In the state shown in Fig. 23(d) the position of the boundary line defined by the edges 71a and 72a is moved in the -Z direction from the state shown in Fig. 23(c) after exposure of the first shot region has been completed. At the moment exposure starts in the second shot region, the boundary line formed by the edges 71a and 72a are optically aligned with the light blocking area (restriction area) on the mask M (the image of the boundary line is formed on the light blocking area).

The operations for moving the vanes 71 and 72 as shown in Figs. 23(c) and 23(d) are executed during stepping operations performed between scan exposures.

Fig. 23(e) is a diagram showing the positional relationship between the vanes 71 and 72 and the first and second shape setting units 21 and 22 during the scanning and exposing of the second shot region. When scanning and exposing the second shot region, the peripheral portion of the first shape setting unit 21 is covered by the vane 71, and the peripheral portion of the second shape setting unit 22 is not covered by the vane 72. Thus, the light beam, of which edge shape is defined by the peripheral portion set by the second shape setting unit 22 and the linear edge 71a of the vane 71, is directed to the mask M and the wafer W.

The movement of the vane 72 of the mask blind 7 in the +Z direction starts when the light beam reaches the end of the pattern region on the mask M in the -Y direction. At this time, the vane 72 moves simultaneously with the mask M so that the image of the edge 72a of the vane 72 is aligned with the light blocking area on the mask M in the -Y direction.

Fig. 23(f) is a diagram showing the positional relationship between the vanes 71 and 72 and the first and second shape setting units 21 and 22 when the exposure of the second shot region has been completed. In this state, the edge 71a of the vane 71, which functions as the first selection member, and the edge 72a of the vane 72, which functions as the second selection member, are aligned to form a boundary line.

Thereafter, the vanes 71 and 72 are integrally moved in the +Z direction and returned to the state shown in Fig. 23(a), and exposure starts in a shot region that is not the first or second shot regions.

The blades 21c and 22c of the first and second shape setting units 21 and 22 are fixed in the exposure operation shown in Fig. 23. However, in the same manner as in the above embodiments, an operation for changing the shape of the peripheral portion may be performed by driving the blades 21c of the first shape setting unit 21 while the first shape setting unit 21 is covered by the vane 71, and an operation for changing the shape of the peripheral portion may be performed by driving the blades 22c of the second shape setting unit 22 while the second shape setting unit 22 is covered by the vane 72.

The present invention is applied to a scanning type exposure apparatus in the above embodiments. However, the present invention is not limited to this application inasmuch as the invention is also applicable to a stationary type exposure apparatus such as a stepper. The present invention is also applicable to a reduction projection exposure apparatus of a step-and-stitch type which combine shot regions.

In the exposure apparatus of the above embodiment, the projection optical system may have magnification for an unit magnification system or an enlargement system in addition to a reduction system. Further, the projection optical system PL may be a reflective system or a reflective refraction system in addition to a refraction system, and the projection image may be an inverted image or an erect image.

A method for filling a medium (typically, a liquid), which has a refraction index greater than 1.1, in the optical path between a projection optical system and photosensitive substrate, that is, a so-called immersion method, may also be applied in the above examples. In this case, as a method for filling a liquid in the optical path between the projection optical system and the photosensitive substrate include a method for locally filling a liquid as disclosed in International Patent Publication No. 99/49504, a method for moving a stage holding a substrate subjected to exposure within a liquid tank as disclosed in Japanese Laid-Open Patent Publication No. 6-124873, and a method for forming a liquid tank of predetermined depth on a stage and holding the substrate therein as disclosed in Japanese Laid-Open Patent Publication No. 10-303114 may be employed.

In the above examples, polarized illumination may be performed as disclosed in, for example, U.S. Patent Application Publication Nos. 2006/0203214, 2006/0158624, and 2006/017090.

The illumination light IL is not limited to ArF excimer laser light (wavelength 193 nm) and ultraviolet light, such as KrF excimer laser light (wavelength 248 nm), and vacuum ultraviolet light, such as F₂ laser light (wavelength 157 nm) may also be used. For example, single wavelength laser light in the visible range or infrared range light oscillated by a DBF semiconductor laser or a fiber laser may be amplified by, for example, a fiber amplifier doped with erbium (or both erbium and ytterbium), and converted to ultraviolet light using a nonlinear optical crystal so as to use the higher harmonic wave.

Further, in the above examples, the illumination light IL of the exposure apparatus is not limited to light having a wavelength 100 nm or greater and may be light having a wavelength of less than 100 nm. For example, an EUV exposure apparatus has been developed in recent years to generate an EUV (extreme ultraviolet) light in the soft X-ray range (for example, wavelength of 5 to 15 nm) and use a reflective type mask and an all reflective-reducing optical system designed for use with such exposure wavelengths (for example, 13. 5 nm) as an SOR or plasma laser light source in order to expose a pattern at 70 nm or less. The present invention is also applicable to this device since scan exposing can be performed by synchronously scanning a mask and wafer using arcuate illumination. The present invention is also applicable to an exposure apparatus that uses a charged particle line such as an electron beam or ion beam.

In the above embodiments, a light transmission type mask (reticle) is used to form a predetermined light blocking pattern (or phase pattern/light attenuation pattern) on a light transmitting substrate. However, in lieu of the reticle, an electron mask (variable form mask) may be used to form a transmission pattern, a reflection pattern, or a light-emitting pattern based on electron data of a pattern that is to be exposed, such as disclosed in U.S. Patent No. 6,778,257.

The present invention is also applicable to an exposure apparatus (lithographic system) that forms a line-and-space pattern on a wafer W by forming interference fringes on the wafer W as disclosed in International Patent Publication No. 2001/035168.

The present invention is also applicable to an exposure apparatus that combines two reticle patterns on a wafer with a projection optical system and performs double exposure at substantially the same time on a single shot region of a wafer during a single scan exposure.

The object on which a pattern is to be formed (object subjected to exposure and irradiated with an energy beam) in the above embodiments and modifications is not limited to a wafer and may be other objects, such as a glass plate, a ceramic substrate, or mask blanks.

The application of the present invention is not limited to exposure apparatuses for manufacturing semiconductors and may broadly be applied, for example, to a liquid crystal exposure apparatus for transferring a liquid crystal display element pattern onto a rectangular glass plate, an exposure apparatus for manufacture organic EL, thin film magnetic heads, photographic elements (CCD and the like), micro machines, and DNA chips. The present invention is not only applicable to an exposure apparatus for manufacturing micro devices such as semiconductor devices and may also be applied to an exposure apparatus for transferring a circuit pattern onto a glass substrate or silicon wafer to manufacture a reticle or mask for use in a light exposure apparatus, EUV exposure apparatus, X-ray exposure apparatus, and electron beam exposure apparatus.

Further, the exposure apparatus of the above examples is manufactured by assembling various subsystems including elements recited in the claims of the present application with a predetermined mechanical accuracy, electrical accuracy, and optical accuracy. In order to ensure such accuracies, adjustments are made before and after assembly, including adjustment of the optical systems to ensure optical accuracy, adjustment of the mechanical systems to ensure mechanical accuracy, and adjustment of the electrical systems to ensure electrical accuracy. The process for assembling the exposure apparatus with the various subsystems includes mutual mechanical connections, electrical circuit wiring connections, and gas pressure circuit piping connections of the various subsystems. Prior to the process for assembling the exposure apparatus with the various subsystems, it is obvious that a process for assembling the individual subsystems is performed. After the process for assembling the exposure apparatus with the various subsystems is completed, total adjustment is performed to ensure each type of accuracy. The exposure apparatus is preferably manufactured in a clean room of which cleanliness and temperature are managed.

The above examples are described to facilitate comprehension of the present invention but should not in any way be construed as limiting the present invention. Accordingly, the elements disclosed in the above embodiments include all equivalents and design modifications that are within the technical scope of the present invention. The various elements of the above embodiments may be combined in any manner.

The variable slit device of the present invention includes selection members which select a first portion of a light beam having a first light intensity distribution set by a first light intensity distribution setting unit and a second portion of the light beam that has a second light intensity distribution set by a second light intensity distribution setting unit. Thus, changes may be quickly made from the first portion of the light beam having the first light intensity distribution to the second portion of the light beam having the second light intensity distribution and from the second portion of the light beam having the second light intensity distribution to the first portion of the light beam having the first light intensity distribution.

The illumination device of the present invention includes the variable slit device of the present invention. Thus, illumination light having a desired shape can be quickly formed, and the illumination light of the desired shape can be irradiated on an illuminated plane in a satisfactory manner.

The exposure apparatus of the present invention includes the illumination device of the present invention. Thus, illumination light of a desired shape can be quickly formed in correspondence with the illumination condition, and a predetermined pattern can be exposed onto a substrate with high accuracy and high throughput.

In the exposure apparatus of the present invention, a light intensity distribution changing means performs part of an operation for setting the second light intensity distribution during an operation for guiding the illumination light, which has a first light intensity distribution under a first illumination condition, to a substrate. Thus, the light intensity distribution of the illumination light can be quickly changed in correspondence with the illumination condition and highly accurate exposure can be performed with high throughput even when the illumination condition is changed.

In the exposure apparatus of the present invention, a light intensity distribution changing means performs part of an operation for setting the second light intensity distribution during an operation for guiding the illumination light, which has a first light intensity distribution, to a substrate. Thus, the light intensity distribution of the illumination light can be quickly changed between exposure of one of a plurality of sections on the substrate and exposure for another one of the sections. This enables highly accurate exposure while maintaining high throughput.

In the device manufacturing method of the present invention, a predetermined pattern is exposed using the exposure apparatus of the present invention. Thus, highly accurate devices can be manufactured with high throughput.

In the exposure method of the present invention, a second light intensity distribution setting step for setting a second light intensity distribution, which is the light intensity distribution of one of two peripheral portions along the longitudinal direction of a slit shape, is simultaneously performed with a transferring step for transferring a predetermined pattern onto a substrate using a light beam having a selected first portion. Thus, when a second portion of light beam having a second light intensity distribution is selected, the light beam can be quickly changed to light beam having the selected second portion.

In the exposure method of the present invention, during the light intensity distribution changing step, part of an operation for setting a second light intensity distribution is performed during a first transferring step for transferring a first pattern group onto a substrate by guiding illumination light having a first light intensity distribution under a first illumination condition onto a substrate through a first pattern group. Thus, the light distribution can be quickly changed to the second light intensity distribution in correspondence with a second illumination condition, and highly accurate exposure can be performed with high throughput even when the illumination condition is changed from the first illumination condition to the second illumination condition.

In the device manufacturing method of the present invention, a first pattern group and a second pattern group are overlapped for exposure using the exposure method of the present invention. Thus, highly accurate devices are manufactured with high throughput.

In the device manufacturing method of the present invention, errors in line width uniformity caused in processes other than the exposure process are corrected in the exposure process. Thus, devices can be manufactured in a satisfactory manner.

The above examples are described to facilitate comprehension of the present invention but should not in any way be construed as limiting the present invention. Accordingly, the elements disclosed in the above examples include all equivalents and design modifications that are within the technical scope of the present invention.

The present disclosure relates to the subject matter described in Japanese Patent Application No. 2006-167234, filed on June 16, 2006.

### INDUSTRIAL APPLICABILITY

The present invention is optimal for use in a variable slit device used in a lithographic process for manufacturing semiconductor devices, liquid crystal display devices, thin film magnetic heads and the like, an illumination device including the variable slit device, an exposure apparatus including the illumination device, an exposure methods for exposing a pattern on a substrate, and a device manufacturing method using the exposure apparatus or the exposure method.

### EXAMPLES

1. A variable slit device for forming illumination light with a slit shape including a longitudinal direction and a lateral direction, the variable slit device being characterized by:
   a first light intensity distribution setting unit which sets a first light intensity distribution, which is the light intensity distribution of a first light beam portion passing by the vicinity of one of a plurality of peripheral portions that transverse the lateral direction of the slit shape;
   a second light intensity distribution setting unit which sets a second light intensity distribution, which is the light intensity distribution of a second light beam portion passing by the vicinity of a further one of the plurality of peripheral portions; and
   a selection member which selectively outputs the first light beam portion and the second light beam portion.
2. The variable slit device according to example 1, being characterized in that:
   the first light intensity setting unit includes a first shape setting unit which sets a rim shape of the first light beam portion; and
   the second light intensity setting portion includes a second shape setting unit which sets a rim shape of the second light beam portion.
3. The variable slit device according to example 2, being characterized in that:
   at least either one of the first shape setting unit and the second shape setting unit includes a plurality of blades which form the rim shape; and
   at least one of the plurality of blades is movable along the lateral direction.
4. The variable slit device according to example 3, further being characterized by:
   a control unit which controls movement of the plurality of blades;
   wherein the control unit moves at least one of the plurality of blades to deform rim shapes of the peripheral portions.
5. The variable slit device according to example 2, being characterized in that:
   the first shape setting unit and the second shape setting unit each include a plurality of blades which form rim shapes of the peripheral portions;
   at least one of the blades in the first shape setting unit and at least one of the blades in the second shape setting unit are movable along the lateral direction to deform the rim shapes of the peripheral portions; and
   a control unit which controls selection by the selection member and movement of the plurality of blades;
   wherein the control unit sets the rim shape of the second light beam portion by moving the at least one of the blades in the second shape setting unit when the selection member is selecting the first light beam portion.
6. The variable slit device according to example 1, being characterized in that the first shape setting unit includes at least one filter member which is insertable in an optical path of the first light beam portion and which includes a predetermined transmission rate distribution.
7. The variable slit device according to any one of examples 1 to 6, being characterized in that the selection member includes an edge portion including a shape elongated in the longitudinal direction of the slit shape and changes positional relationship of the plurality of peripheral portions of the illumination light and the edge portion of the selection member along the lateral direction.
8. The variable slit device according to example 7, being characterized in that:
   the edge portion includes a linear shape extending in the longitudinal direction; and
   the selection member sets the shape of the peripheral portion of the first light beam portion or the second light beam portion to a linear shape by changing the positional relationship.
9. The variable slit device according to example 7 or 8, being characterized in that:
   the edge portion of the selection member is movable in the lateral direction; and
   movement of the edge portion of the selection member in the lateral direction selectively blocks the first light beam portion and the second light beam portion.
10. The variable slit device according to example 9, being characterized in that the selection member includes a first selection member arranged in the vicinity of the one of the peripheral portions and a second selection member arranged on the further one of the peripheral portions.
11. The variable slit device according to example 10, being characterized in that at least one of the first selection member and the second selection member is inclinable relative to the longitudinal direction.
12. The variable slit device according to example 10 or 11, being characterized in that the first selection member and the second selection member are formed integrally.
13. The variable slit device according to any one of examples 1 to 6, being characterized in that the selection member moves light beam directed toward the first and second light intensity distribution setting units along the lateral direction.
14. The variable slit device according to any one of examples 1 to 13, being characterized in that the first and second light intensity distribution units and the selection member are arranged in an order in which light beam passes through the variable slit device.
15. The variable slit device according to any one of examples 1 to 13, being characterized in that the selection member and the first and second light intensity distribution units are arranged in an order in which light beam passes through the variable slit device.
16. A variable slit device for forming illumination light with a slit shape including a longitudinal direction and a lateral direction, the variable slit device being characterized by:
   a first shape setting unit which sets a shape of one of a plurality of peripheral portions that transverse the lateral direction of the slit shape;
   a second shape setting unit which sets a shape of a further one of the plurality of peripheral portions; and
   a selection member which selectively outputs light beam that passes through the first shape setting unit and light beam that passes through the second shape setting unit.
17. The variable slit device according to example 16, being characterized in that the second shape setting unit changes the shape of the further one of the peripheral portions when the light beam is output through the first shape setting unit by the selection member.
18. The variable slit device according to example 16 or 17, being characterized in that the selection member includes an edge portion including a shape elongated in the longitudinal direction of the slit shape.
19. The variable slit device according to example 18, being characterized in that the edge portion of the selection member selectively blocks light beam passing through the first shape setting unit, light beam passing through the first shape setting unit and light beam passing through the second shape setting unit, or light beam passing through the second shape setting unit.
20. The variable slit device according to any one of examples 16 to 19, further being characterized by: a control unit which controls the first and second shape setting units and the selection member.
21. The variable slit device according to any one of examples 1 to 20, being characterized in that the slit shape is substantially polygonal or substantially arcuate.
22. The variable slit device according to any one of examples 1 to 15, being characterized in that the slit shape is used in an illumination device for guiding illumination light to an illuminated plane.
23. The variable slit device according to example 22, being characterized in that the selection member outputs only one of the first light beam portion and the second light beam portion when the illumination light is guided to the illuminated plane.
24. The variable slit device according to any one of examples 16 to 21, being characterized in that the slit shape is used in an illumination device for guiding illumination light to an illuminated plane.
25. The variable slit device according to example 24, being characterized in that when the illumination light is guided to the illuminated plane, the selection member selectively blocks light beam passing through the first shape setting unit, light beam passing through the first shape setting unit and light beam passing through the second shape setting unit, or light beam passing through the second shape setting unit.
26. The variable slit device according to any one of examples 22 to 25, being characterized in that the selection member is arranged at a position optically conjugated to the illuminated plane.
27. An illumination device for guiding illumination light including a slit shape to an illuminated plane, the illumination device being characterized by:
   the variable slit device which changes a shape of the illumination light according to any one of examples 1 to 26.
28. The illumination device according to example 27, being characterized in that the shape of the illumination light formed by the variable slit device is set in correspondence with illumination conditions for illuminating the illuminated plane.
29. An exposure apparatus for forming an illumination region including a slit shape on a substrate with illumination light passing through a predetermined pattern and changing positional relationship of the illumination region and the substrate along a direction intersecting a longitudinal direction of the slit shape to transfer the predetermined pattern onto the substrate, the exposure apparatus being characterized by:
   the illumination device which illuminates the predetermined pattern with the illumination light according to example 27 or 28.
30. The exposure apparatus according to example 29, being characterized in that:
   the predetermined pattern is transferred to a plurality of sections on the substrate; and
   the selection member performs a selection operation between a transfer operation performed on one of the plurality of sections and a transfer operation performed on a further one of the plurality of sections.
31. An exposure apparatus for guiding illumination light passing through a predetermined pattern to a substrate to transfer the predetermined pattern onto the substrate, the exposure apparatus being characterized by:
   an illumination condition changing means which changes illumination conditions for the illumination light guided to the substrate at least between a first illumination condition and a second illumination condition; and
   a light intensity distribution changing means which changes light intensity distribution of the illumination light on the substrate at least between a first light intensity distribution corresponding to the first illumination condition and a second light intensity distribution corresponding to the second illumination condition;
   wherein the light intensity distribution changing means performs part of a setting operation of the second light intensity distribution during an operation for guiding illumination light including the first light intensity distribution to the substrate under the first illumination condition.
32. An exposure apparatus for guiding illumination light passing through a predetermined pattern to a substrate to transfer the predetermined pattern to a plurality of sections on the substrate, the exposure apparatus being characterized by:
   a light intensity distribution changing means which changes light intensity distribution of the illumination light on the substrate between a first light intensity distribution and a second light intensity distribution;
   wherein the light intensity distribution changing means performs part of an operation for setting the second light intensity distribution during at least one of an operation for guiding illumination light including the first light intensity distribution to one of the plurality of sections on the substrate and an operation for moving the substrate from the one of the plurality of sections to a further one of the plurality of sections.
33. A device manufacturing method being characterized by:
   an exposing step of exposing the predetermined pattern onto the substrate with the exposure apparatus according to any one of examples 29 to 32; and
   a developing step of developing the substrate that has been exposed in the exposing step.
34. An exposure method for forming an illumination region including a slit shape on a substrate with illumination light passing through a predetermined pattern and changing positional relationship of the illumination region and the substrate along a direction intersecting a longitudinal direction of the slit shape to transfer the predetermined pattern onto the substrate, the method being characterized by:
   a first light intensity distribution setting step of setting a first light intensity distribution, which is the light intensity distribution of a first light beam portion passing by the vicinity of one of a plurality of peripheral portions that transverse a lateral direction of the slit shape;
   a second light intensity distribution setting step of setting a second light intensity distribution, which is the light intensity distribution of a further one of the plurality of peripheral portions;
   a selecting step of selecting the first light beam portion from the first light beam portion and the second light beam portion; and
   a transferring step of transferring the predetermined pattern onto the substrate using the selected first light beam portion;
   wherein the second light intensity distribution setting step and the transferring step are performed simultaneously.
35. The exposure method according to example 34, wherein the predetermined pattern includes a first pattern group formed in a first pattern region and a second pattern group formed in a second pattern region that differs from the first pattern region, with the transferring step transferring the first pattern group onto the substrate, the method further being characterized by:
   a further selecting step of selecting the second light beam portion set in the second light intensity setting step; and
   a further transferring step of transferring the second pattern group onto the substrate using the selected second light beam portion.
36. The exposure method according to example 34, further being characterized by:
   a further selecting step of selecting the second light beam portion set in the second light intensity setting step; and
   a further transferring step of transferring the predetermined pattern onto the substrate using the selected second light beam portion;
   wherein the further transferring step transfers the predetermined pattern onto one of a plurality of sections on the substrate that differs from the section onto which the predetermined pattern is transferred in the transferring step.
37. An exposure method for guiding illumination light to a substrate through a predetermined pattern including a first pattern group formed in a first pattern region and a second pattern group formed in a second pattern region that differs from the first pattern region to transfer the predetermined pattern onto the substrate, the exposure method being characterized by:
   an illumination condition changing step of changing illumination conditions for the illumination light guided to the substrate at least between a first illumination condition and a second illumination condition;
   a light intensity distribution changing step of changing light intensity distribution of the illumination light on the substrate at least between a first light intensity distribution corresponding to the first illumination condition and a second light intensity distribution corresponding to the second illumination condition;
   a first transferring step of transferring the first pattern group onto the substrate by guiding to the substrate through the first pattern group illumination light including the first light intensity distribution under the first illumination condition; and
   a second transferring step of transferring the second pattern group onto the substrate so as to overlap the first pattern group transferred in the first transferring step by guiding to the substrate through the second pattern group illumination light including the second light intensity distribution under the second illumination condition;
   wherein in the light intensity distribution changing step, part of an operation for setting the second light intensity distribution is performed during the first transferring step.
38. A device manufacturing method being characterized by:
   an exposing step of exposing the predetermined pattern onto the substrate using the exposure method according to claim 34; and
   a developing step of developing the substrate that has been exposed in the exposing step.
39. A device manufacturing method being characterized by:
   an exposing step of exposing the first pattern group and the second pattern group onto the substrate using the exposure method according to any one of claims 35 to 37; and
   a developing step of developing the substrate that has been exposed in the exposing step.
40. A device manufacturing method being characterized by:
   an applying step of applying photosensitive material to a substrate;
   an exposing step of exposing a predetermined pattern onto the substrate to which the photosensitive material has been applied;
   a developing step of developing the substrate onto which the predetermined pattern has been exposed; and
   a processing step of performing predetermined processing on the substrate that has been developed;
   wherein the exposing step corrects a line width uniformity error on the substrate resulting from at least one of the applying step, the developing step, and the processing step.
41. The device manufacturing method according to claim 40, being characterized in that at least one of the applying step, the developing step, and the processing step includes a heating step of heating the substrate.
42. The device manufacturing method according to example 40 or 41, being characterized in that:
   the exposing step exposes the substrate to obtain a predetermined accumulated exposure amount distribution;
   wherein the predetermined accumulated exposure amount distribution is set to reduce the line width uniformity error.
43. The device manufacturing method according to any one of examples 40 to 42, being characterized in that the exposing step includes a first exposing step of exposing the predetermined pattern onto one of a plurality of sections on the substrate with exposure light including a first accumulated exposure amount distribution, and a second exposing step of exposing the predetermined pattern onto a different one of the plurality of sections on the substrate with exposure light including a second accumulated exposure amount distribution that differs from the first accumulated exposure amount distribution.
44. An exposure apparatus for use in an applying step of applying photosensitive material to a substrate, an exposing step of exposing a predetermined pattern onto the substrate to which the photosensitive material has been applied, a developing step of developing the substrate onto which the predetermined pattern has been exposed, and a processing step of performing predetermined processing on the substrate that has been developed, the exposure apparatus being characterized by:
   correcting during the exposing step a line width uniformity error on the substrate resulting from at least one of the applying step, the developing step, and the processing step.
45. The exposure apparatus according to example 44, being characterized in that at least one of the applying step, the developing step, and the processing step includes a heating step of heating the substrate.
46. The exposure apparatus according to example 44 or 45, being characterized by:
   exposing the substrate with exposure light including an accumulated exposure amount distribution set to reduce the line width uniformity error.
47. The exposure apparatus according to any one of examples 44 to 46, being characterized by: exposing the predetermined pattern onto one of a plurality of sections on the substrate with exposure light including a first accumulated exposure amount distribution, and exposing the predetermined pattern onto a different one of the plurality of sections on the substrate with exposure light including a second accumulated exposure amount distribution that differs from the first accumulated exposure amount distribution.

## Claims

1. A device manufacturing method being **characterized by**:
an applying step of applying photosensitive material to a substrate (W);
a scanning exposing step of exposing a predetermined pattern onto the substrate (W) to which the photosensitive material has been applied;
a developing step of developing the substrate (W) onto which the predetermined pattern has been exposed; and
a processing step of performing predetermined processing on the substrate (W) that has been developed;
wherein in order to reduce a line width uniformity error on the substrate (W) resulting from at least one of the applying step, the developing step, and the processing step, the scanning exposing step includes a first exposing step of exposing the predetermined pattern onto one of a plurality of sections on the substrate (W) with exposure light including a first accumulated exposure amount distribution in a plane of the substrate (W) and perpendicular to a scanning direction, and a second exposing step of exposing the predetermined pattern onto a different one of the plurality of sections on the substrate (W) with exposure light including a second accumulated exposure amount distribution in a plane of the substrate (W) and perpendicular to a scanning direction, that differs from the first accumulated exposure amount distribution.

2. The device manufacturing method according to claim 1, being **characterized in that** at least one of the applying step, the developing step, and the processing step includes a heating step of heating the substrate (W) .

3. The device manufacturing method according to claim 1 or 2, being **characterized in that**:
the exposing step exposes the substrate (W) to obtain a predetermined accumulated exposure amount distribution; wherein the predetermined accumulated exposure amount distribution is set to reduce the line width uniformity error.

4. An exposure apparatus configured to carry out a device manufacturing method comprising an applying step of applying photosensitive material to a substrate (W), a scanning exposing step of exposing a predetermined pattern onto the substrate (W) to which the photosensitive material has been applied, a developing step of developing the substrate onto which the predetermined pattern has been exposed, and a processing step of performing predetermined processing on the substrate that has been developed, the exposure apparatus being **characterized in that** it is configured for
correcting during the exposing step a line width uniformity error on the substrate (W) resulting from at least one of the applying step, the developing step, and the processing step, and exposing the predetermined pattern onto one of a plurality of sections on the substrate (W) with exposure light including a first accumulated exposure amount distribution, and exposing the predetermined pattern onto a different one of the plurality of sections on the substrate with exposure light including a second accumulated exposure amount distribution in a plane of the substrate (W) and perpendicular to a scanning direction, that differs from the first accumulated exposure amount distribution.

5. The exposure apparatus according to claim 4, being **characterized in that** at least one of the applying step, the developing step, and the processing step includes a heating step of heating the substrate (W).

6. The exposure apparatus according to claim 4 or 5, being **characterized by**:
exposing the substrate (W) with exposure light including an accumulated exposure amount distribution set to reduce the line width uniformity error.

## Patentansprüche

1. Einrichtungsherstellungsverfahren, das **gekennzeichnet ist durch**:
einen Aufbringschritt mit einem Aufbringen eines lichtempfindlichen Materials auf ein Substrat (W);
einen Scanbelichtungsschritt mit einem Belichten einer vorbestimmten Struktur auf dem Substrat (W), auf welches das lichtempfindliche Material aufgebracht worden ist;
einen Entwicklungsschritt mit einem Entwickeln des Substrats (W), auf dem die vorbestimmte Struktur belichtet worden ist; und
einen Bearbeitungsschritt mit einem Ausführen einer vorbestimmten Bearbeitung des Substrats (W), das entwickelt worden ist;
wobei, um einen Uniformitätsfehler einer Linienbreite auf dem Substrat (W) zu reduzieren, der von dem Aufbringschritt, dem Entwicklungsschritt und/oder dem Bearbeitungsschritt resultiert, der Scanbelichtungsschritt einen ersten Belichtungsschritt mit einem Belichten der vorbestimmten Struktur an einer von einer Vielzahl von Sektionen an dem Substrat (W) mit Belichtungslicht, einschließlich einer ersten kumulierten Belichtungsmengenverteilung in einer Ebene des Substrat (W) und senkrecht zu einer Scanrichtung, und einen zweiten Belichtungsschritt mit einem Belichten der vorbestimmten Struktur an einer anderen von der Vielzahl von Sektionen an dem Substrat (W) mit Belichtungslicht einschließlich einer zweiten kumulierten Belichtungsmengenverteilung in einer Ebene des Substrats (W) und senkrecht zu einer Scanrichtung, die sich von der ersten kumulierten Belichtungsmengenverteilung unterscheidet, einschließt.

2. Einrichtungsherstellungsverfahren nach Anspruch 1, **dadurch gekennzeichnet, dass** der Aufbringschritt, der Entwicklungsschritt und/oder der Bearbeitungsschritt einen Erwärmungsschritt mit einem Erwärmen des Substrats (W) einschließt.

3. Einrichtungsherstellungsverfahren nach Anspruch 1 oder 2, **dadurch gekennzeichnet, dass**:
der Belichtungsschritt das Substrat (W) belichtet, um eine vorbestimmte kumulierte Belichtungsmengenverteilung zu erhalten, wobei die vorbestimmte kumulierte Belichtungsmengenverteilung eingestellt wird, den Uniformitätsfehler einer Linienbreite zu reduzieren.

4. Belichtungsvorrichtung, die eingerichtet ist, ein Einrichtungsherstellungsverfahren auszuführen, das einen Aufbringschritt mit einem Aufbringen eines lichtempfindlichen Materials auf ein Substrat (W), einen Scanbelichtungsschritt mit einem Belichten einer vorbestimmten Struktur an dem Substrat (W), auf welches das lichtempfindliche Material aufgebracht worden ist, einen Entwicklungsschritt mit einem Entwickeln des Substrats, an dem die vorbestimmte Struktur belichtet worden ist, und einen Bearbeitungsschritt mit einem Ausführen einer vorbestimmten Bearbeitung an dem entwickelten Substrat umfasst, wobei die Belichtungsvorrichtung **dadurch gekennzeichnet ist, dass** sie während des Belichtungsschritts zum Korrigieren eines Uniformitätsfehlers einer Linienbreite an dem Substrat (W), der von dem Aufbringschritt, dem Entwicklungsschritt und/oder dem Bearbeitungsschritt resultiert, und zum Belichten der vorbestimmten Struktur an einer von einer Vielzahl von Sektionen an dem Substrat (W) mit Belichtungslicht einschließlich einer ersten kumulierten Belichtungsmengenverteilung und zum Belichten der vorbestimmten Struktur an einer anderen der Vielzahl von Sektionen an dem Substrat mit Belichtungslicht einschließlich einer zweiten kumulierten Belichtungsmengenverteilung in einer Ebene des Substrats (W) und senkrecht zu einer Scanrichtung, die sich von der ersten kumulierten Belichtungsmengenverteilung unterscheidet, eingerichtet ist.

5. Belichtungsvorrichtung nach Anspruch 4, **dadurch gekennzeichnet, dass** der Aufbringschritt, der Entwicklungsschritt und/oder der Bearbeitungsschritt einen Arbeitsschritt mit einem Erwärmen des Substrats (W) einschließt.

6. Belichtungsvorrichtung nach Anspruch 4 oder 5, **gekennzeichnet durch**:
Belichten des Substrats (W) mit Belichtungslicht einschließlich einer kumulierten Belichtungsmengenverteilung, die eingestellt ist, um den Uniformitätsfehler einer Linienbreite zu reduzieren.

## Revendications

1. Procédé de fabrication de dispositif **caractérisé par** :
une étape d'application d'un matériau photosensible sur un substrat (W) ;
une étape d'exposition par balayage pour exposer un motif prédéterminé sur le substrat (W) sur lequel le matériau photosensible a été appliqué ;
une étape de développement du substrat (W) sur lequel le motif prédéterminé a été exposé ; et
une étape de traitement pour effectuer un traitement prédéterminé sur le substrat (W) qui a été développé ;
dans lequel afin de réduire une erreur d'uniformité de largeur de ligne sur le substrat (W) résultant d'au moins une étape parmi l'étape d'application, l'étape de développement, et l'étape de traitement, l'étape d'exposition par balayage inclut une première étape d'exposition du motif prédéterminé sur l'une d'une pluralité de sections sur le substrat (W) avec une lumière d'exposition incluant une première distribution de quantité d'exposition accumulée dans un plan du substrat (W) et perpendiculaire à une direction de balayage, et une seconde étape d'exposition du motif prédéterminé sur une différente de la pluralité de sections sur le substrat (W) avec une lumière d'exposition incluant une seconde distribution de quantité d'exposition accumulée dans un plan du substrat (W) et perpendiculaire à une direction de balayage, qui diffère de la première distribution de quantité d'exposition accumulée.

2. Procédé de fabrication de dispositif selon la revendication 1, **caractérisé en ce qu'**au moins l'une parmi l'étape d'application, l'étape de développement, et l'étape de traitement inclut une étape de chauffage du substrat (W).

3. Procédé de fabrication de dispositif selon la revendication 1 ou 2, **caractérisé en ce que** :
l'étape d'exposition expose le substrat (W) pour obtenir une distribution de quantité d'exposition accumulée prédéterminée ; dans lequel la distribution de quantité d'exposition accumulée prédéterminée est réglée pour réduire l'erreur d'uniformité de largeur de ligne.

4. Appareil d'exposition configuré pour exécuter un procédé de fabrication de dispositif comprenant une étape d'application d'un matériau photosensible sur un substrat (W), une étape d'exposition par balayage pour exposer un motif prédéterminé sur le substrat (W) sur lequel le matériau photosensible a été appliqué, une étape de développement du substrat sur lequel le motif prédéterminé a été exposé, et une étape de traitement pour effectuer un traitement prédéterminé sur le substrat qui a été développé, l'appareil d'exposition étant **caractérisé en ce qu'**il est configuré pour corriger pendant l'étape d'exposition une erreur d'uniformité de largeur de ligne sur le substrat (W) résultant d'au moins une étape parmi l'étape d'application, l'étape de développement, et l'étape de traitement, et exposer le motif prédéterminé sur l'une d'une pluralité de sections sur le substrat (W) avec une lumière d'exposition incluant une première distribution de quantité d'exposition accumulée, et exposer le motif prédéterminé sur une autre de la pluralité de sections sur le substrat avec une lumière d'exposition incluant une seconde distribution de quantité d'exposition accumulée dans un plan du substrat (W) et perpendiculaire à une direction de balayage, qui diffère de la première distribution de quantité d'exposition accumulée.

5. Appareil d'exposition selon la revendication 4, **caractérisé en ce qu'**au moins l'une parmi l'étape d'application, l'étape de développement, et l'étape de traitement inclut une étape de chauffage du substrat (W).

6. Appareil d'exposition selon la revendication 4 ou 5, **caractérisé par** :
l'exposition du substrat (W) avec une lumière d'exposition incluant un ensemble de distribution de quantité d'exposition accumulée réglé pour réduire l'erreur d'uniformité de largeur de ligne.
